# EUROPEAN PATENT APPLICATION

(11) **EP 4 445 765 A1**
(43) Date of publication of application: **16.10.2024**
(21) Application number: 21967263.1
(22) Date of filing: 10.12.2021
(51) Int. Cl.: A24F 40/40, A24F 40/51

(54) **POWER SUPPLY UNIT FOR AEROSOL GENERATING DEVICE**

(71) Applicant: Japan Tobacco Inc., Tokyo 105-6927 (JP)
(72) Inventor: MARUBASHI, Keiji, Tokyo 130-8603 (JP); KITAHARA, Minoru, Tokyo 130-8603 (JP)
(74) Representative: Hoffmann Eitle
(86) International application number: PCT/JP2021/045600
(87) International publication number: WO 2023/105771

(57) **Abstract**

Provided is a power supply unit for an aerosol generating device, the power supply unit preventing sensor failure during production and improving production yield. A power supply unit 100 comprises: a power source ba; an inhalation sensor 15 capable of producing an output according to inhalation of a user; an MCU 6 configured to control power supply to a liquid heater that vaporizes an aerosol source on the basis of the output of the inhalation sensor 15; a puff sensor substrate 21 on which the inhalation sensor 15 is mounted; a case 3a that accommodates the power source ba, the inhalation sensor 15, the MCU 6, and the puff sensor substrate 21; and a sensor holding portion 55 into which the inhalation sensor 15 is inserted and that fixes the position of the inhalation sensor 15 in the case 3a. The inhalation sensor 15 protrudes from the puff sensor substrate 21 in a plan view seen in the thickness direction of the puff sensor substrate 21.

## Description

### TECHNICAL FIELD

The present invention relates to a power supply unit of an aerosol generation device.

### BACKGROUND ART

Patent Literature 1 discloses an inhaler including a pressure sensor mounted on a substrate and a sensor holder attached to the pressure sensor.

Patent Literature 2 discloses an aerosol inhaler including an intake sensor provided on a circuit substrate.

### CITATION LIST

### PATENT LITERATURE

Patent Literature 1: Japanese Unexamined Patent Application Publication No. 2020-65543
Patent Literature 2: Japanese Patent Publication No. 6633788

### SUMMARY OF INVENTION

### TECHNICAL PROBLEM

In an aerosol generation device, a sensor for detecting user inhalation is preferably fixed at an appropriate position in order to be able to accurately detect the user inhalation. In addition, since such a sensor is a precision component, it is necessary to prevent a failure when fixing the sensor.

An object of the present invention is to provide a power supply unit of an aerosol generation device capable of preventing a failure of a sensor during manufacturing and increasing a manufacturing yield.

### SOLUTION TO PROBLEM

An aspect of the present invention is a power supply unit of an aerosol generation device, the power supply unit including: a power supply; an inhalation sensor configured to provide an output in response to inhalation of a user; a controller configured to control, based on the output of the inhalation sensor, power supply to an atomizer that atomizes an aerosol source; a circuit substrate on which the inhalation sensor is mounted; a housing configured to accommodate the power supply, the inhalation sensor, the controller, and the circuit substrate; and a sensor holding portion into which the inhalation sensor is inserted and which fixes a position of the inhalation sensor inside the housing, in which the inhalation sensor protrudes from the circuit substrate in a plan view viewed in a thickness direction of the circuit substrate.

### ADVANTAGEOUS EFFECTS OF INVENTION

According to the present invention, a failure of the sensor during manufacturing can be prevented and a manufacturing yield can be increased.

### BRIEF DESCRIPTION OF DRAWINGS

FIG. 1 is a perspective view of an aerosol generation device 200.
FIG. 2 is another perspective view of the aerosol generation device 200.
FIG. 3 is an exploded perspective view of the aerosol generation device 200.
FIG. 4 is a left side view of an internal unit 2A.
FIG. 5 is a right side view of the internal unit 2A.
FIG. 6 is a perspective view showing a configuration of a heating unit 60 and a circuit unit 70 of the internal unit 2A.
FIG. 7 is a view showing a front surface 201 of a main substrate 20.
FIG. 8 is a view showing a back surface 202 of the main substrate 20.
FIG. 9 is a plan view viewed in a direction perpendicular to an element mounting surface of a puff sensor substrate 21 (in other words, a thickness direction of the puff sensor substrate 21).
FIG. 10 is an exploded perspective view of the puff sensor substrate 21, a sensor holding portion 55, and an inhalation sensor 15 shown in FIG. 9.
FIG. 11 is a perspective view of a chassis 50 from which the sensor holding portion 55 is removed.
FIG. 12 is a diagram showing a schematic configuration of a circuit provided in the main substrate 20.
FIG. 13 is a circuit diagram showing electronic components related to an operation in a heating mode and extracted from the circuit shown in FIG. 12.
FIG. 14 is a circuit diagram showing electronic components related to a heating control of a sheet heater HTR and a liquid heater, a driving control of a vibration motor 13, and a driving control of an LED 21D and extracted from the circuit shown in FIG. 12.
FIG. 15 is a circuit diagram corresponding to FIG. 13 in a case where an FF9 is omitted.
FIG. 16 is a circuit diagram corresponding to FIG. 13 in a case where the FF9 and an AND gate 10 are omitted.
FIG. 17 is an exploded perspective view of the heating unit 60 and a flow path forming body 19 shown in FIG. 6.
FIG. 18 is a developed view of a heater FPC 24 shown in FIG. 17.
FIG. 19 is a circuit diagram showing electronic components related to restart of an MCU 6 and extracted from the circuit shown in FIG. 12.
FIG. 20 is a diagram showing a modification of a restart circuit RBT shown in FIG. 19.

### DESCRIPTION OF EMBODIMENTS

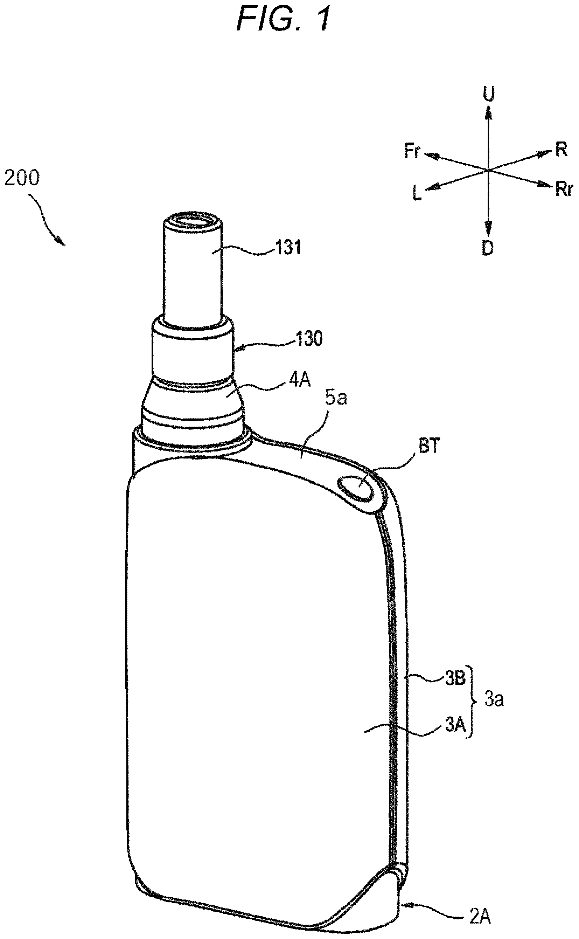

Hereinafter, a power supply unit of an aerosol generation device according to an embodiment of the present invention will be described. First, an aerosol generation device including a power supply unit of the present embodiment will be described with reference to FIGS. 1 to 8.

### (Aerosol Generation Device)

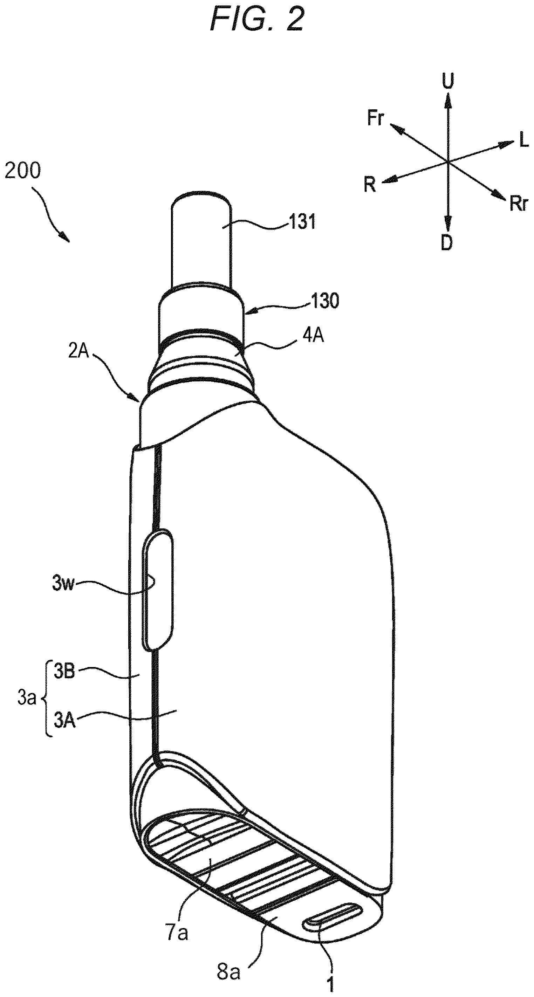

An aerosol generation device 200 is a device for generating flavored aerosol without combustion and inhaling the generated aerosol. The aerosol generation device 200 preferably has a size that fits in hands, and for example, as shown in FIGS. 1 and 2, has a rounded, substantially rectangular parallelepiped shape. The shape of the aerosol generation device 200 is not limited thereto, and may be a bar shape, an egg shape, or the like. In the following description, three directions orthogonal to one another in the aerosol generation device 200 are referred to as an upper-lower direction, a front-rear direction, and a left-right direction in descending order of length. In the following description, for convenience, as shown in FIGS. 1 to 8, front, rear, left, right, upper, and lower are defined, a front side is denoted by Fr, a rear side is denoted by Rr, a left side is denoted by L, a right side is denoted by R, an upper side is denoted by U, and a lower side is denoted by D.

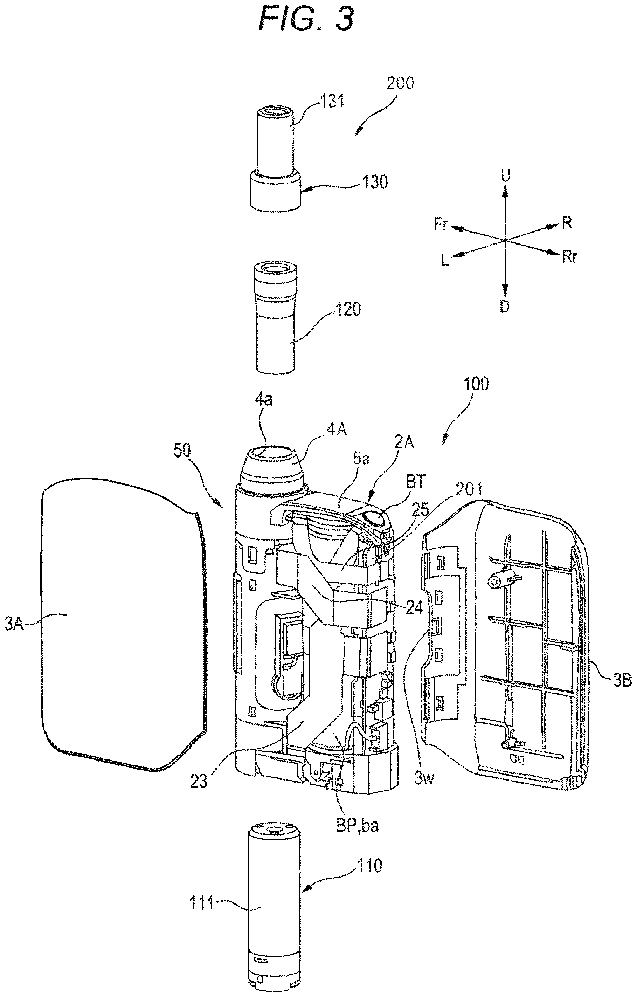

Referring also to FIG. 3, the aerosol generation device 200 includes a power supply unit 100, a first cartridge 110, and a second cartridge 120. The first cartridge 110 and the second cartridge 120 are detachable with respect to the power supply unit 100. In other words, the first cartridge 110 and the second cartridge 120 are replaceable.

### (Power Supply Unit)

The power supply unit 100 includes an internal unit 2A and a case 3a, and at least a part of the internal unit 2A is accommodated in the case 3a.

The case 3a includes a first case 3A and a second case 3B that are detachable in the left-right direction (thickness direction), the first case 3A and the second case 3B are assembled in the left-right direction (thickness direction), thereby forming a front surface, a rear surface, a left surface, and a right surface of the power supply unit 100. Specifically, the first case 3A is supported on a left surface of a chassis 50 to be described later in the internal unit 2A, the second case 3B is supported on a right surface of the chassis 50, and the internal unit 2A is accommodated in the case 3. A capsule holder 4A is provided on a front side on the upper surface of the power supply unit 100. The capsule holder 4A is provided with an opening portion 4a that is opened upward. The capsule holder 4A is configured such that the second cartridge 120 can be inserted through the opening portion 4a. On the second cartridge 120, a mouth piece 130 is detachably provided.

The upper surface of the power supply unit 100 is formed by an organic light-emitting diode (OLED) cover 5a disposed behind the opening portion 4a, and the lower surface of the power supply unit 100 is formed by a pivotable lower lid 7a and a lower cover 8a provided with a charging terminal 1.

An inclined surface inclined downward toward the rear is provided between the upper surface and the rear surface of the power supply unit 100. The inclined surface is provided with an operation unit operable by a user. The operation unit of the present embodiment is a button-type switch BT, but may be implemented by a touch panel or the like. The operation unit is used to start/shut off/operate a micro controller unit (MCU) 6 and various sensors, which will be described later, based on a use intention of the user.

The charging terminal 1 accessible from the lower cover 8a is configured to be electrically connected to an external power supply (not shown) capable of supplying electric power to the power supply unit 100 to charge a power supply ba provided in a battery pack BP. The charging terminal 1 is, for example, a receptacle into which a mating plug can be inserted. As the charging terminal 1, a receptacle into which various USB terminals or the like can be inserted can be used. As an example, in the present embodiment, the charging terminal 1 is a USB Type-C receptacle.

The charging terminal 1 may include, for example, a power receiving coil, and may be configured to receive electric power transmitted from the external power supply in a non-contact manner. In this case, a method for wireless power transfer (WPT) may be of an electromagnetic induction type, a magnetic resonance type, or a combination of the electromagnetic induction type and the magnetic resonance type. As another example, the charging terminal 1 may be connectable to various USB terminals or the like, and may include the power receiving coil described above.

As shown in FIGS. 3 to 6, the internal unit 2A includes the battery pack BP, the chassis 50, a heating unit 60, a circuit unit 70, a notification unit, and various sensors.

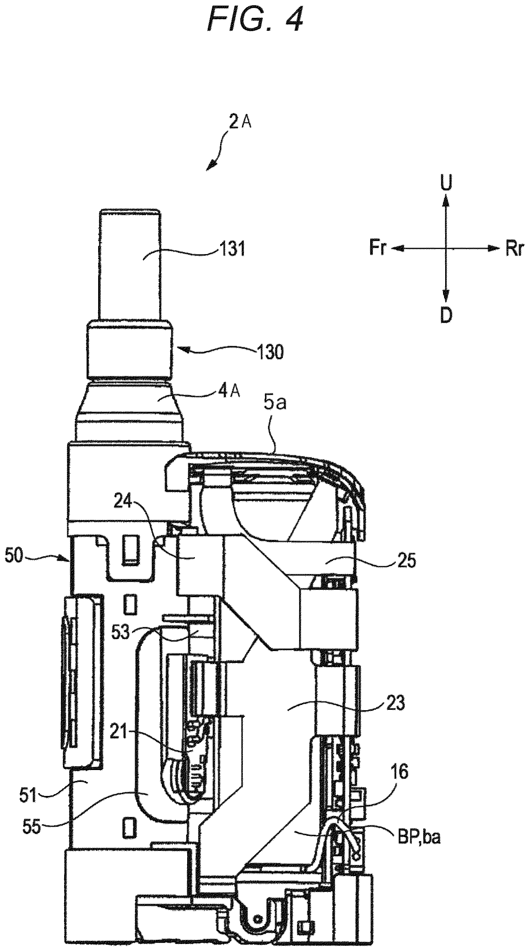

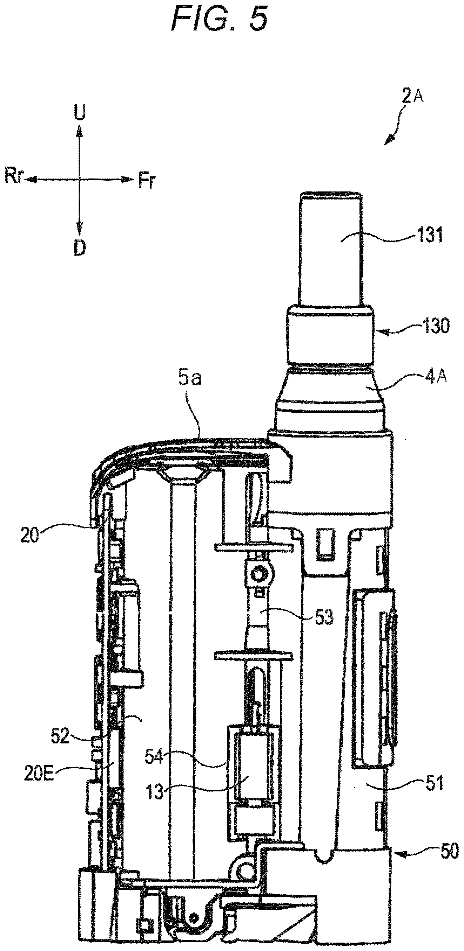

As shown in FIGS. 4 and 5, the chassis 50 includes a cylindrical cartridge holding portion 51 located on a front side, a half-cylindrical battery holding portion 52 located on a rear side and having a left side cut out, a plate-shaped coupling portion 53 coupling the cartridge holding portion 51 and the battery holding portion 52, a motor holding portion 54 provided below and on a right side of the coupling portion 53 in a manner of straddling the cartridge holding portion 51 and the battery holding portion 52, and a sensor holding portion 55 provided on a left rear side of the cartridge holding portion 51.

The first cartridge 110 is inserted into the cartridge holding portion 51 from below in a state where the lower lid 7a is opened. When the lower lid 7a is closed in a state where the first cartridge 110 is inserted, the first cartridge 110 is accommodated in the cartridge holding portion 51. The capsule holder 4A is attached to an upper portion of the cartridge holding portion 51. In the cartridge holding portion 51, a vertically long through hole is provided on a front side, and a remaining amount of an aerosol source of the first cartridge 110 and light of a light emitting diode (LED) 21D to be described later can be visually observed through a remaining amount confirmation window 3w provided at a joint of the first case 3A and the second case 3B. The first cartridge 110 will be described later.

The battery pack BP is disposed in the battery holding portion 52. The battery pack BP includes the power supply ba and a power supply thermistor for detecting a temperature of the power supply ba. The power supply ba is a chargeable secondary battery, an electric double-layer capacitor, or the like, and is preferably a lithium ion secondary battery. An electrolyte of the power supply ba may be implemented by one or a combination of a gel electrolyte, an electrolytic solution, a solid electrolyte, and an ionic liquid.

A vibration motor 13 is disposed in the motor holding portion 54. An inhalation sensor 15 to be described later, which provides an output in response to an inhalation operation (puff operation) of the user, is disposed in the sensor holding portion 55.

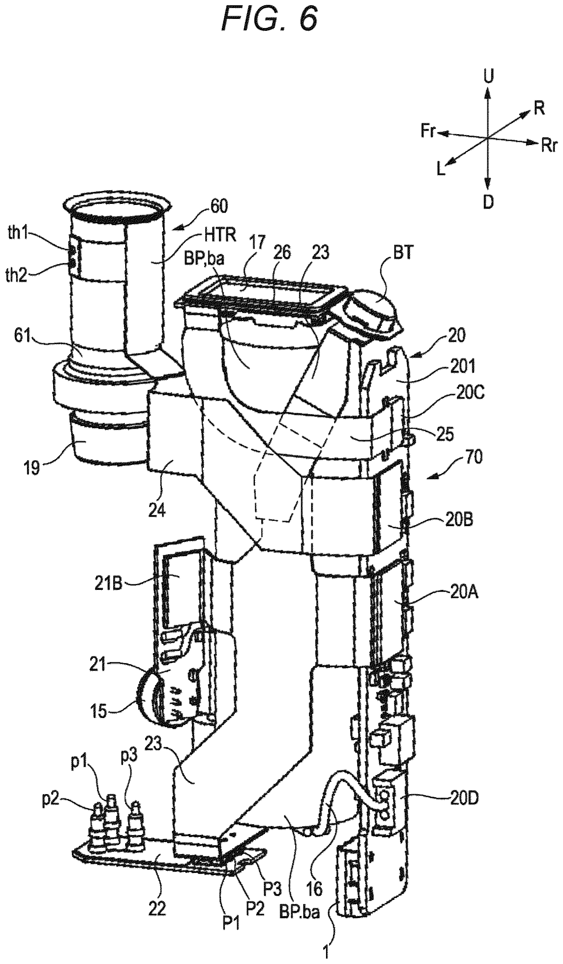

As shown in FIG. 6, the heating unit 60 includes a cylindrical heat transfer tube 61 and a sheet heater HTR wound around an outer periphery of the heat transfer tube 61. The capsule holder 4A is separately provided around the sheet heater HTR. An air layer between the capsule holder 4A and the sheet heater HTR functions as a heat insulator. A lower portion of the second cartridge 120 inserted from the opening portion 4a of the capsule holder 4A is accommodated in the heat transfer tube 61, and a lower portion of the second cartridge 120 is heated by the sheet heater HTR. Accordingly, as compared with a case where the heating unit 60 is not provided, a flavor source stored in the second cartridge 120 easily releases a flavor, so that the aerosol is easily flavored.

The heating unit 60 may be an element capable of heating the second cartridge 120. Examples of the element include a resistance heating element, a ceramic heater, and an induction-heating-type heater. As the resistance heating element, for example, a heating element having a positive temperature coefficient (PTC) characteristic in which an electrical resistance value increases as the temperature increases is preferably used. Alternatively, a heating element having a negative temperature coefficient (NTC) characteristic in which the electrical resistance value decreases as the temperature increases may be used. The heating unit 60 has a function of defining a flow path of air to be supplied to the second cartridge 120 and a function of heating the second cartridge 120.

The notification unit notifies various kinds of information such as a charging state of the power supply ba, a remaining amount of the first cartridge 110, and a remaining amount of the second cartridge 120. The notification unit of the present embodiment includes the LED 21D and the vibration motor 13. The notification unit may be implemented by a light emitting element such as the LED 21D, a vibration element such as the vibration motor 13, or a sound output element. The notification unit may be a combination of two or more elements among the light emitting element, the vibration element, and the sound output element.

The various sensors include the inhalation sensor 15 that detects the puff operation (inhalation operation) of the user, a heater temperature sensor that detects a temperature of the sheet heater HTR, and the like.

The inhalation sensor 15 includes, for example, a capacitor microphone, a pressure sensor, and a flow rate sensor. A plurality of inhalation sensors 15 may be disposed apart from each other, and the puff operation may be detected based on a difference between output values of the inhalation sensors 15. The heater temperature sensor includes a first thermistor th1 and a second thermistor th2. The first thermistor th1 and the second thermistor th2 are preferably in contact with or close to the sheet heater HTR. When the sheet heater HTR has the PTC characteristic or the NTC characteristic, the sheet heater HTR may be used for the heater temperature sensor. The heater temperature sensor includes two thermistors, but may include one thermistor.

The circuit unit 70 includes four rigid circuit substrates, three flexible printed circuits (FPCs) or flexible printed circuit substrates, a plurality of integrated circuits (ICs), and a plurality of elements. The four circuit substrates include a main substrate 20, a puff sensor substrate 21, a pogo pin substrate 22, and an OLED substrate 26. The three FPCs include a main FPC 23, a heater FPC 24, and an OLED FPC 25.

The main substrate 20 is disposed between the battery pack BP and a rear surface of the case 3a (the rear surface of the power supply unit 100) such that an element mounting surface faces the front-rear direction. The main substrate 20 is configured by laminating a plurality of layers (six layers in the present embodiment) of substrates, and electronic components (elements) such as the MCU 6 and a charging IC 3 are mounted thereon.

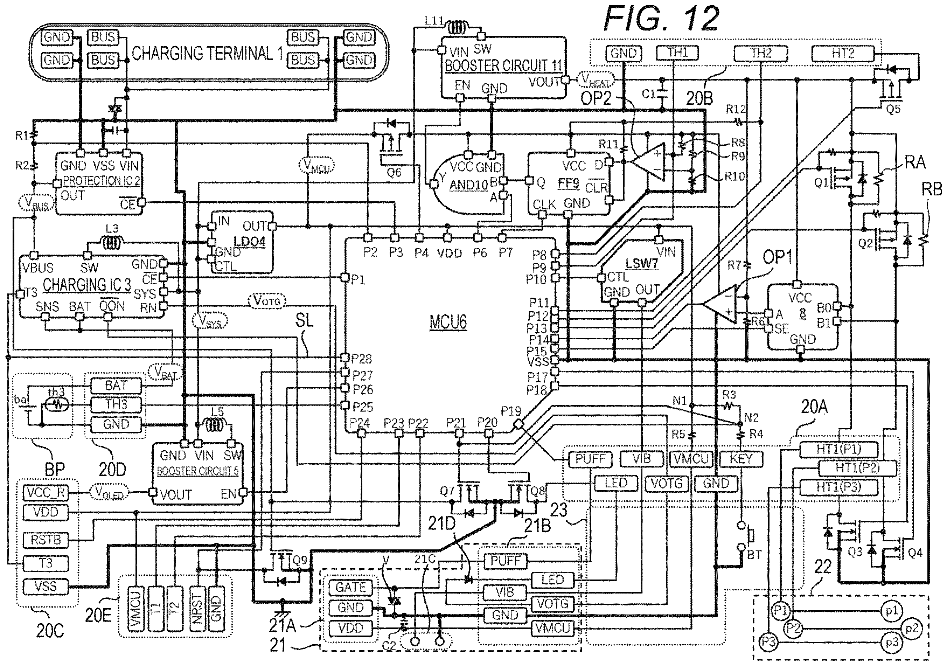

As to be described later in detail with reference to FIG. 12 and the like, the MCU 6 is a control device that is connected to various sensor devices such as the inhalation sensor 15, the operation unit, the notification unit, and a memory or the like that stores the number of times of puff operations, a load, an energization time to the sheet heater HTR, and the like, and performs various controls of the aerosol generation device 200. Specifically, the MCU 6 is implemented by a processor as a main component, and further includes a storage medium such as a random access memory (RAM) necessary for an operation of the processor and a read only memory (ROM) storing various kinds of information. For example, the processor in the present description is an electrical circuit in which circuit elements such as semiconductor devices are combined. A part of the elements (for example, the inhalation sensor 15 and the memory) connected to the MCU 6 may be provided inside the MCU 6 as a function of the MCU 6 itself.

The charging IC 3 is an IC that performs charging control of the power supply ba by the electric power received via the charging terminal 1, and supplies the electric power of the power supply ba to the electronic components and the like on the main substrate 20.

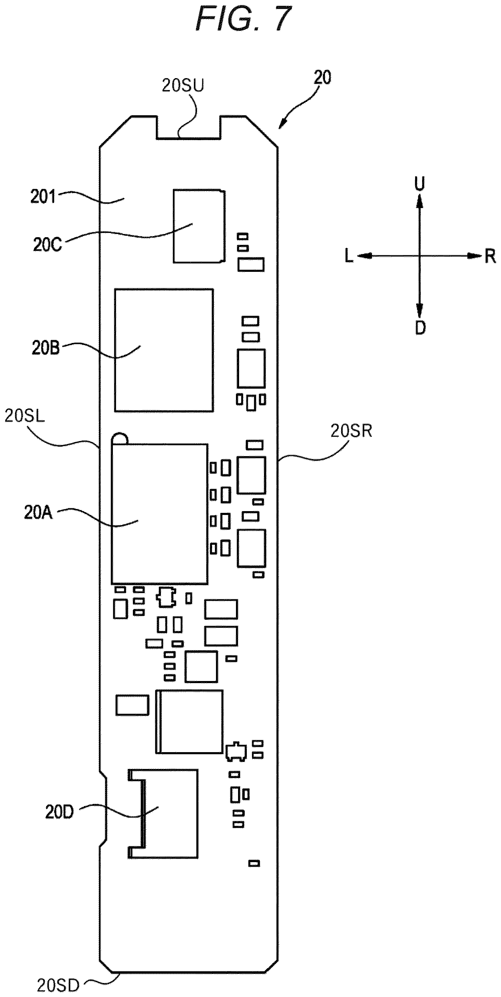

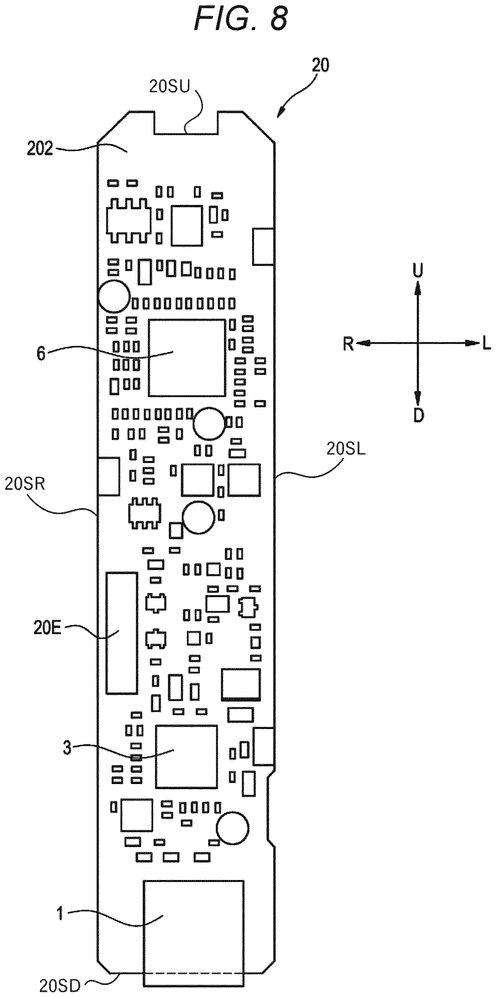

The main substrate 20 will be described more specifically with reference to FIGS. 7 and 8. Hereinafter, a surface of the main substrate 20 facing rearward is referred to as a front surface 201 for convenience, and a surface of the main substrate 20 facing forward is referred to as a back surface 202 for convenience. FIG. 7 is a diagram showing the front surface 201 of the main substrate 20, and FIG. 8 is a diagram showing the back surface 202 of the main substrate 20. The main substrate 20 has a plate shape extending vertically, and FIGS. 7 and 8 show an upper side surface 20SU which is a side surface on an upper side and a lower side surface 20SD which is a side surface on a lower side, as side surfaces orthogonal to a longitudinal direction of the main substrate 20. A left side surface 20SL which is a side surface on a left side and a right side surface 20SR which is a side surface on a right side are shown as side surfaces orthogonal to a short direction of the main substrate 20.

As shown in FIG. 8, the MCU 6 and the charging IC 3 are mounted on the back surface 202 of the main substrate 20 together with the charging terminal 1. A debug connector 20E is further mounted on the back surface 202. The debug connector 20E is an interface for rewriting a program of the MCU 6 from an external device such as a personal computer, and for example, a connector conforming to a Serial Wire Debug (SWD) standard is used. Meanwhile, as shown in FIG. 7, an OLED connector 20C, a heater connector 20B, a main connector 20A, and a battery connector 20D which is connected to the battery pack BP via a lead wire 16 (see FIG. 6) are mounted on the front surface 201 of the main substrate 20.

As shown in FIGS. 4 and 6, the puff sensor substrate 21 is disposed on the sensor holding portion 55 of the chassis 50 such that an element mounting surface faces a right front side and a left rear side. The inhalation sensor 15 is mounted on the puff sensor substrate 21.

As shown in FIG. 6, the OLED substrate 26 is disposed between the battery pack BP and the OLED cover 5a such that an element mounting surface faces the upper-lower direction. An OLED panel 17 is mounted on the OLED substrate 26.

As shown in FIG. 6, the pogo pin substrate 22 is disposed on the lower lid 7a such that an element mounting surface faces the upper-lower direction in a state where the lower lid 7a is closed. The pogo pin substrate 22 is provided with input-side contact points P1 to P3 to which electric power is supplied from the main substrate 20 via the main FPC 23, and pogo pins p1 to p3 which are connectors electrically connected to a load provided in the first cartridge 110. The input-side contact points P1 to P3 are electrically connected to the main FPC 23 only in a state where the lower lid 7a is closed. The three pogo pins p1 to p3 are provided at equal intervals in a peripheral direction, and at least two pogo pins are electrically connected to a positive terminal and a negative terminal of the first cartridge 110 accommodated in the cartridge holding portion 51.

A left side of the battery pack BP held by the battery holding portion 52 is exposed from the battery holding portion 52 due to the half-cylindrical battery holding portion 52. As shown in FIGS. 3, 4, and 6, the main FPC 23, the heater FPC 24, and the OLED FPC 25 are disposed to overlap one another in a space between the left side of the battery pack BP and the first case 3A, which is formed by cutting out the battery holding portion 52.

Among the three FPCs, the main FPC 23 is routed closest to battery pack BP, the OLED FPC 25 is routed to partially overlap the main FPC 23, and further the heater FPC 24 is routed to overlap the OLED FPC 25. That is, the heater FPC 24 to which the largest electric power is supplied among the three FPCs is routed to be farthest from the battery pack BP. The main FPC 23 has a developed shape of a substantially cross shape, and is folded rearward at a position overlapping the heater FPC 24. That is, the main FPC 23 is a folded wiring. Although the folded portion of the main FPC 23 is likely to float in the left-right direction, the heater FPC 24 and the OLED FPC 25 overlap this portion, thereby preventing such floating. The switch BT is directly mounted on the main FPC 23 without using a rigid substrate or the like.

The OLED FPC 25 has one end connected to the OLED connector 20C of the main substrate 20 and the other end connected to the OLED substrate 26.

The main FPC 23 connects the main connector 20A of the main substrate 20, the switch BT of the operation unit, a connector 21B of the puff sensor substrate 21, and the input-side contact points P1 to P3 of the pogo pin substrate 22.

The heater FPC 24 has one end connected to the heater connector 20B of the main substrate 20, and the other end integrally formed with the sheet heater HTR.

### (First Cartridge)

The first cartridge 110 includes, inside a cylindrical cartridge case 111, a reservoir that stores an aerosol source, an electrical load that atomizes the aerosol source, a wick that draws the aerosol source from the reservoir to the load, and an aerosol flow path through which aerosol generated by atomization of the aerosol source flows toward the second cartridge 120. The aerosol source contains a liquid such as glycerin, propylene glycol, or water.

The load is a heating element that heats, without combustion, the aerosol source by electric power supplied from the power supply ba via the pogo pins p1 to p3 of the pogo pin substrate 22, and is implemented by, for example, a heating wire (coil) wound at a predetermined pitch. The load atomizes the aerosol source by heating the aerosol source. As the load, a heating resistor, a ceramic heater, an induction-heating-type heater, and the like may be used. Hereinafter, the load provided in the first cartridge 110 is also referred to as a liquid heater.

The aerosol flow path is connected to the second cartridge 120 via a flow path forming body 19 (see FIG. 6) accommodated in the cartridge holding portion 51 of the chassis 50.

### (Second Cartridge)

The second cartridge 120 stores a flavor source. When the second cartridge 120 is heated by the sheet heater HTR, the flavor source is heated. The second cartridge 120 flavors the aerosol when the aerosol generated by atomizing the aerosol source by the liquid heater passes through the flavor source. As a raw material piece constituting the flavor source, it is possible to use a molded product obtained by molding a shredded tobacco or a tobacco raw material into granules. The flavor source may be formed of plants other than tobacco (for example, mint, Chinese medicine, and herb). The flavor source may contain a fragrance such as menthol.

The aerosol generation device 200 can generate flavored aerosol using the aerosol source and the flavor source. That is, the aerosol source and the flavor source constitute an aerosol generation source that generates the flavored aerosol.

The aerosol generation source in the aerosol generation device 200 is a portion to be replaced and used by the user. In this portion, for example, one first cartridge 110 and one or a plurality of (for example, five) second cartridges 120 are provided as one set to the user. The battery pack BP can be repeatedly charged and discharged as long as the power supply ba is not significantly deteriorated. Accordingly, in the aerosol generation device 200, a replacement frequency of the power supply unit 100 or the battery pack BP is lowest, a replacement frequency of the first cartridge 110 is second lowest, and a replacement frequency of the second cartridge 120 is highest. The first cartridge 110 and the second cartridge 120 may be integrated into one cartridge. Instead of the flavor source, a chemical agent or the like may be added to the aerosol source.

In the aerosol generation device 200 configured as described above, air flowing in from an air intake port (not shown) provided in the case 3a or the internal unit 2A passes near the load of the first cartridge 110. The load atomizes the aerosol source drawn from the reservoir by the wick. The aerosol generated by atomization flows through the aerosol flow path together with the air flowing in from the intake port, and is supplied to the second cartridge 120 via the flow path forming body 19. The aerosol supplied to the second cartridge 120 is flavored when passing through the flavor source, and is supplied to an inhalation port 131 of the mouth piece 130.

Hereinafter, the connectors mounted on the main substrate 20 supported by the chassis 50 will be described in detail.

A connector of the main FPC 23, a connector of the heater FPC 24, a connector of the OLED FPC 25, and the lead wire 16 are respectively inserted rightward into the main connector 20A, the heater connector 20B, the OLED connector 20C, and the battery connector 20D which are mounted on the front surface 201 of the main substrate 20 shown in FIG. 7. The rightward insertion refers to insertion in a direction from left to right. The connector of the main FPC 23, the connector of the heater FPC 24, the connector of the OLED FPC 25, and the lead wire 16 are each routed from a position of the inserted connector to the battery pack BP side across the left side surface 20SL of the main substrate 20. A connector of a connection cable (not shown) is inserted leftward into the debug connector 20E mounted on the back surface 202 of the main substrate 20 shown in FIG. 8. The leftward insertion refers to insertion in a direction from right to left. A connector of a USB cable (not shown) is inserted upward into the charging terminal 1 mounted on the back surface 202 of the main substrate 20. The upward insertion refers to insertion in a direction from a lower side to an upper side.

Thus, the four connectors (the OLED connector 20C, the heater connector 20B, the main connector 20A, and the battery connector 20D) to which the wirings (FPC and the lead wire) are constantly connected and the debug connector 20E and the charging terminal 1 to which the wirings (the connection cable and the USB cable) are connected only when necessary are mounted on different element mounting surfaces of the main substrate 20. Therefore, routing of the wirings connected to the four connectors is facilitated. In particular, as described above, by making the insertion directions of the wirings with respect to the four connectors the same, routing of the wirings is further facilitated, and a design for reducing an extra space or the like is facilitated, so that the power supply unit 100 can be reduced in size.

In addition, the insertion directions of the wirings with respect to the four connectors mounted on the front surface 201 are common to the right direction. Meanwhile, the insertion direction of the wiring with respect to the debug connector 20E mounted on the back surface 202 is a direction different from (specifically, opposite to) those of the four connectors. Accordingly, when the connection cable is inserted into the debug connector 20E, the connection cable can be prevented from interfering with the wirings inserted into the four connectors. The insertion direction of the wiring with respect to the charging terminal 1 is a direction different from the insertion direction of the wiring with respect to the debug connector 20E (specifically, a direction orthogonal to the insertion direction). Accordingly, even when the connection cable is inserted into the debug connector 20E and the USB cable is connected to the charging terminal 1, interference between the two cables can be prevented.

Further, the connection cable can be inserted into and removed from the debug connector 20E by detaching only the second case 3B of the case 3a from the chassis 50. In other words, the connection cable can be inserted into and removed from the debug connector 20E even when the first case 3A of the case 3a is attached. In a state where only the second case 3B of the case 3a is detached from the chassis 50 (a state where the first case 3A is attached), the four connectors and the wirings connected thereto are not exposed. As a result, a person can be prevented from touching the four connectors on the front surface 201 and the wirings connected thereto when the connection cable for the debug connector 20E is inserted and removed.

As shown in FIG. 3, the front surface 201 of the main substrate 20 faces a side opposite to a battery pack BP side. In other words, a distance between the front surface 201 of the main substrate 20 and the rear surface of the case 3a is smaller than a distance between the back surface 202 of the main substrate 20 and a front surface of the case 3a. Further, there is no other components constituting the internal unit 2A between the front surface 201 of the main substrate 20 and an inner wall of the case 3a (the rear surface of the case 3a) facing the front surface 201. As a result, the distance between the front surface 201 and the case 3a is minimized, and the power supply unit 100 is reduced in size.

Next, a holding mechanism of the inhalation sensor 15 in the case 3a will be described in detail.

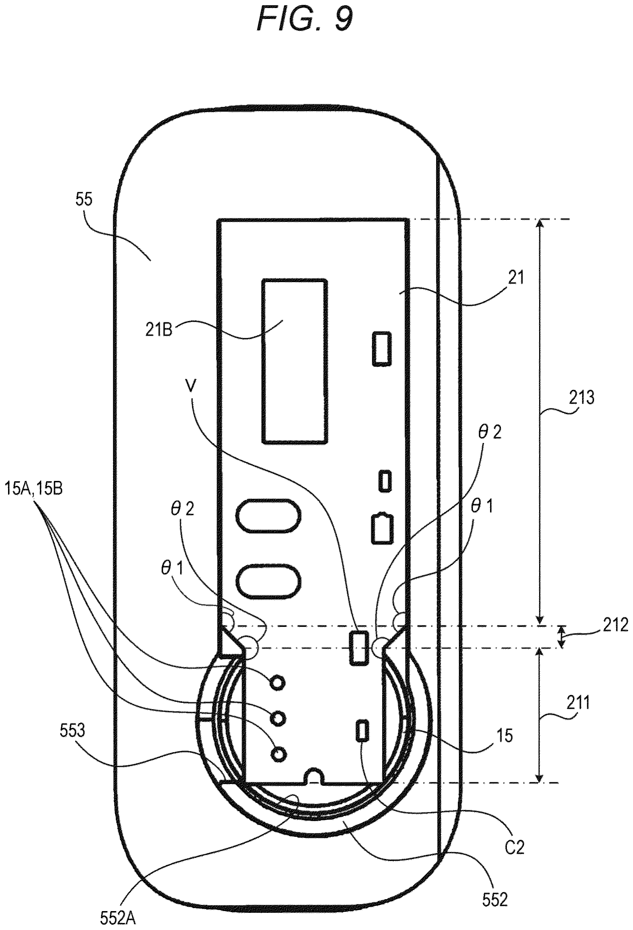

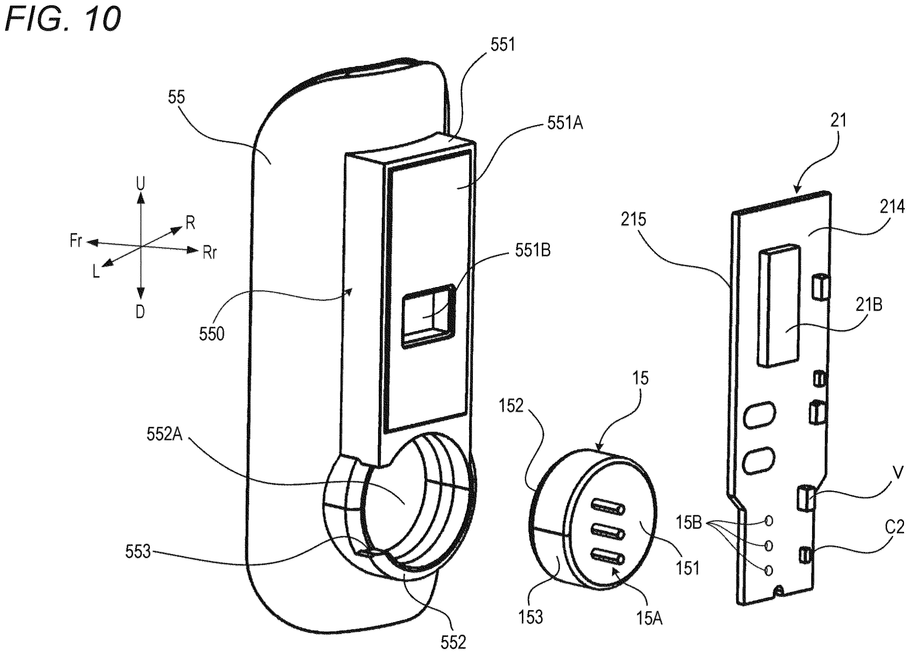

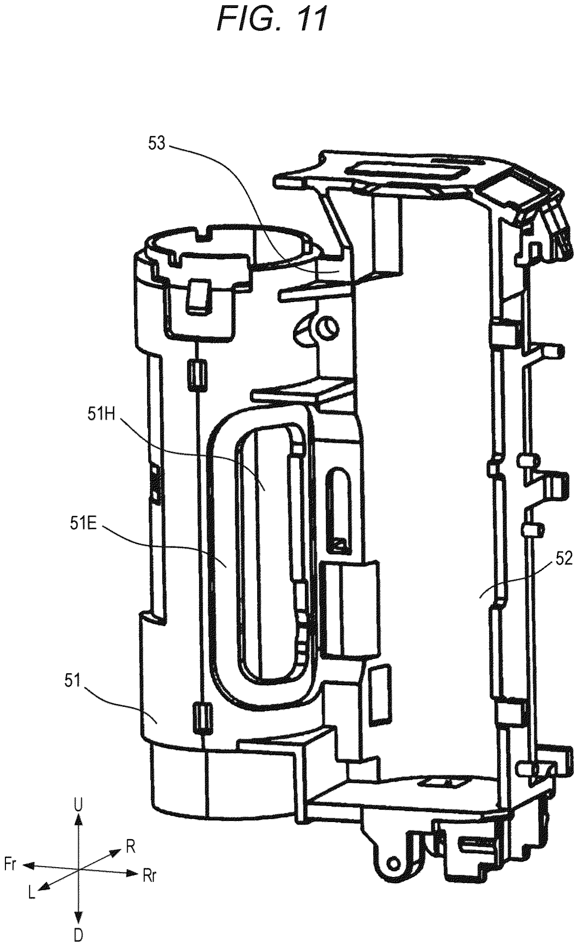

FIGS. 9 and 10 are diagrams showing detailed configurations of the puff sensor substrate 21 and the sensor holding portion 55. FIG. 9 is a plan view viewed in a direction perpendicular to the element mounting surface of the puff sensor substrate 21 (in other words, a thickness direction of the puff sensor substrate 21). FIG. 10 is an exploded perspective view of the puff sensor substrate 21, the sensor holding portion 55, and the inhalation sensor 15 shown in FIG. 9. FIG. 11 is a perspective view of the chassis 50 from which the sensor holding portion 55 is removed.

As shown in FIG. 10, the inhalation sensor 15 has a substantially columnar outer shape, and includes a fixed electrode 151 disposed at one end in an axial direction, a movable electrode 152 disposed at the other end in the axial direction and movable in the axial direction with respect to the fixed electrode 151, and a ring-shaped side surface 153. A terminal group 15A including an output terminal, a ground terminal, and a power supply terminal of the inhalation sensor 15 protrudes from a surface of the inhalation sensor 15 on a fixed electrode 151 side.

As shown in FIGS. 9 and 10, the puff sensor substrate 21 has a plate shape extending in the upper-lower direction. Hereinafter, a surface of the puff sensor substrate 21 opposite to a sensor holding portion 55 side is referred to as a front surface 214 for convenience, and a surface of the puff sensor substrate 21 on the sensor holding portion 55 side is referred to as a back surface 215 for convenience. A length of the puff sensor substrate 21 in a short direction is referred to as a width.

As shown in FIG. 9, the puff sensor substrate 21 includes a first portion 211 that is disposed at one end (lower end) in a longitudinal direction and has a smallest width, a third portion 213 that is disposed above and away from the first portion 211 and has a largest width, and a second portion 212 that connects the first portion 211 and the third portion 213. A width of the second portion 212 increases from the first portion 211 toward the third portion 213, is larger than the width of the first portion 211, and is smaller than the width of the third portion 213. In the puff sensor substrate 21, since the width gradually changes due to the second portion 212, a conductive pattern passing near an edge of the puff sensor substrate 21 does not have an acute angle curve at a portion where the width changes. Accordingly, parasitic resistance and parasitic inductance of the conductive pattern are reduced, and heat and noise which may be generated on the puff sensor substrate 21 are reduced. More specifically, in the plan view of FIG. 9, an angle θ1 of a vertex formed by the third portion 213 and the second portion 212 is 90 degrees or more, and an angle θ2 of a vertex formed by the second portion 212 and the first portion 211 is 90 degrees or more, thus it is easy to provide the conductive pattern along the angle, and the conductive pattern can be prevented from becoming an acute angle.

The inhalation sensor 15 is mounted on the back surface 215 of the first portion 211. Three through holes 15B penetrating in the thickness direction are formed in the first portion 211. The terminal group 15A of the inhalation sensor 15 is inserted into the through holes 15B from a back surface 215 side. The puff sensor substrate 21 is provided with a puff sensor connector 21A, which will be described later, electrically connected to the connector 21B, and the terminal group 15A of the inhalation sensor 15 inserted through the through holes 15B is electrically connected to the puff sensor connector 21A. An output signal of the inhalation sensor 15 is input to the MCU 6 via the puff sensor connector 21A, the connector 21B, and the main FPC 23 connected to the connector 21B. As shown in FIG. 9, the width of the first portion 211 is small enough to allow the inhalation sensor 15 to protrude outward. That is, the inhalation sensor 15 has a portion protruding outward from the puff sensor substrate 21. Further, a width of the inhalation sensor 15 is the same as the width of the third portion 213. The width of the inhalation sensor 15 may be smaller than the width of the third portion 213. As described above, since the width of the third portion 213 is set to be equal to or larger than the width of the inhalation sensor 15, more electronic components can be mounted on the puff sensor substrate 21.

As shown in FIG. 11, an opening 51H is formed in a left rear surface of the cartridge holding portion 51 that defines a substantially columnar cavity for accommodating the first cartridge 110. A peripheral edge portion 51E of the opening 51H is slightly recessed, the sensor holding portion 55 is fixed to the peripheral edge portion 51E by an adhesive or the like, and the opening 51H is closed by the sensor holding portion 55.

The sensor holding portion 55 has a curved shape corresponding to a curved shape of an outer peripheral surface of the substantially cylindrical cartridge holding portion 51. That is, when viewed from above, the sensor holding portion 55 has a shape along the peripheral direction of the cartridge holding portion 51. By forming the sensor holding portion 55 in such a curved shape, a region inside the case 3a can be effectively used, which can contribute to the reduction in size of the power supply unit 100.

As shown in FIG. 10, the sensor holding portion 55 includes a protruding portion 550 that protrudes leftward and rearward and extends in the upper-lower direction. The protruding portion 550 includes an upper portion 551 having a flat surface 551A in which a recess 551B is formed, and a substantially annular lower portion 552 disposed on a lower side of the upper portion 551. An inner diameter of a through hole 552A formed in the lower portion 552 is substantially equal to an outer diameter of the inhalation sensor 15.

When the inhalation sensor 15 mounted on the puff sensor substrate 21 is press-fitted into the through hole 552A, an inner peripheral surface of the lower portion 552 abuts against the side surface 153 of the inhalation sensor 15, and the inhalation sensor 15 and the puff sensor substrate 21 are supported by the sensor holding portion 55 as shown in FIG. 9. In a state shown in FIG. 9, since the movable electrode 152 faces the cartridge holding portion 51, the inhalation sensor 15 can detect a pressure fluctuation in an internal space of the cartridge holding portion 51. Since the pressure fluctuation of the internal space occurs when the user performs the inhalation, the inhalation sensor 15 can detect the inhalation of the user. In the state shown in FIG. 9, the LED 21D mounted on the back surface 215 of the puff sensor substrate 21 faces the recess 551B of the sensor holding portion 55. The sensor holding portion 55 or the recess 551B is made of a light-transmitting material, and light from the LED 21D passes through the opening 51H of the cartridge holding portion 51 and illuminates the aerosol source of the first cartridge 110 accommodated in the cartridge holding portion 51. This makes it easier for the user to visually confirm a remaining amount of the aerosol source in the first cartridge 110 through the remaining amount confirmation window 3w.

As described above, the side surface 153 of the inhalation sensor 15 has a portion protruding outward from the puff sensor substrate 21. Therefore, after the inhalation sensor 15 is mounted on the puff sensor substrate 21, the inhalation sensor 15 can be easily press-fitted into the through hole 552A by gripping the side surface 153. Therefore, during manufacturing of the power supply unit 100, a risk of touching sensitive components such as the movable electrode 152 and the fixed electrode 151 of the inhalation sensor 15 with a finger or the like is reduced, and a failure of the inhalation sensor 15 can be prevented.

As shown in FIGS. 9 and 10, a cutout 553 is provided at a part of a peripheral edge portion of the lower portion 552 of the sensor holding portion 55. The presence of the cutout 553 makes it easy to maintain a state where the side surface 153 of the inhalation sensor 15 is gripped in a process of press-fitting the inhalation sensor 15 into the through hole 552A. Therefore, the inhalation sensor 15 can be more easily press-fitted into the sensor holding portion 55.

As shown in FIG. 4, the cutout 533 of the sensor holding portion 55 is exposed to the outside in a state where the first case 3A of the case 3a is removed from the chassis 50. Therefore, as compared with a configuration in which the cutout 533 is not exposed to the outside in a state where the case 3a is removed from the chassis 50, maintenance of the inhalation sensor 15 and attachment work to the sensor holding portion 55 can be facilitated.

The sensor holding portion 55 is disposed such that a radial direction of the through hole 552A (a direction along a plane orthogonal to a direction in which the through hole 552A extends) intersects two directions (the short direction and the thickness direction in the example of the drawing) among the longitudinal direction (the upper-lower direction), the short direction (the front-rear direction), and the thickness direction (the left-right direction) of the power supply unit 100. For example, when it is assumed that the sensor holding portion 55 is fixed to a rear surface of the cartridge holding portion 51 such that the short direction coincides with the left-right direction and the longitudinal direction coincides with the upper-lower direction, the front-rear direction intersects the radial direction of the through hole 552A, but both the upper-lower direction and the thickness direction are parallel to the radial direction of the through hole 552A. In such a configuration, a thickness (a length in the left-right direction) and a width (a length in the front-rear direction) of the internal unit 2A increase. In contrast, according to the configuration of the present embodiment in which the sensor holding portion 55 is fixed to the obliquely left rear surface of the cartridge holding portion 51, the thickness and the width of the internal unit 2A can be reduced, and thus the power supply unit 100 can be reduced in size.

Further, for example, it is assumed that the aerosol generation device 200 has an elongated tubular shape as a whole, and the capsule holder 4A, the cartridge holding portion 51, and the battery pack BP are linearly arranged. In this case, for example, when it is assumed that the sensor holding portion 55 is fixed to a left surface of the cartridge holding portion 51 such that the short direction coincides with the front-rear direction and the longitudinal direction coincides with the upper-lower direction, the thickness direction intersects the radial direction of the through hole 552A, but both the upper-lower direction and the front-rear direction are parallel to the radial direction of the through hole 552A. In such a configuration, the thickness and width of the internal unit 2A increase. In contrast, according to the configuration of the present embodiment in which the sensor holding portion 55 is fixed to the obliquely left rear surface of the cartridge holding portion 51, the thickness and the width of the internal unit 2A can be reduced, and thus the power supply unit 100 can be reduced in size.

On the front surface 214 of the puff sensor substrate 21, the connector 21B electrically connected to the puff sensor connector 21A and a vibration motor connector 21C to be described later; a varistor V serving as a protective component for protecting other electric components mounted on the puff sensor substrate 21 or the MCU 6 from a signal output from the output terminal of the inhalation sensor 15; and a capacitor C2 serving as a protective component for protecting the inhalation sensor 15 from power input to the power supply terminal of the inhalation sensor 15 are mounted. No IC other than the inhalation sensor 15 is mounted on the puff sensor substrate 21. As described above, since the puff sensor substrate 21 does not include an IC that can be a noise generation source other than the inhalation sensor 15, the inhalation sensor 15 can be stably operated.

As shown in FIG. 9, the capacitor C2 is mounted on the first portion 211. The varistor V is mounted across the first portion 211 and the second portion 212. Thus, the capacitor C2 and the varistor V are mounted at a position close to the terminal group 15A of the inhalation sensor 15 when viewed in the thickness direction of the puff sensor substrate 21, and thereby noise input to the inhalation sensor 15 or output from the inhalation sensor 15 can be more quickly processed by the protective components.

As described above, the inhalation sensor 15 supported by the chassis 50 inside the case 3a is not exposed to the outside when the first case 3A is not detached from the chassis 50. In other words, the inhalation sensor 15 is exposed to the outside only when the first case 3A is detached from the chassis 50. Since the inhalation sensor 15 is not exposed to the outside, for example, when only the second case 3B is detached from the chassis 50 and the debug connector 20E is used, an advantage that the inhalation sensor 15 is less likely to fail can be obtained.

### (Circuit Structure)

FIG. 12 is a diagram showing a schematic configuration of a circuit provided in the main substrate 20. In addition to the circuit of the main substrate 20, FIG. 12 shows the main FPC 23 connected to the main connector 20A of the main substrate 20, the puff sensor substrate 21 connected to the main FPC 23, the pogo pin substrate 22 connected to the main FPC 23, and the battery pack BP connected to the battery connector 20D.

A wiring indicated by a thick solid line in FIG. 12 is a wiring having the same potential as a reference potential (a ground potential, 0 V as an example below) of the power supply unit 100 (a wiring connected to a ground provided in the power supply unit 100), and the wiring is hereinafter referred to as a ground line.

The main substrate 20 is provided with, as main ICs which are electronic components in each of which a plurality of circuit elements are formed into a chip, a protection IC 2; the charging IC 3; an low dropout (LDO) regulator (hereinafter, referred to as LDO) 4; a booster circuit 5 implemented by a DC/DC converter; the MCU 6; a load switch (hereinafter, referred to as LSW) 7 configured by combining a capacitor, a resistor, a transistor, and the like; a multiplexer 8; a flip-flop (hereinafter, referred to as FF) 9; an AND gate (simply referred to as "AND" in FIG. 12) 10; a booster circuit 11 implemented by a DC/DC converter; an operational amplifier OP1; and an operational amplifier OP2.

The main substrate 20 is further provided with switches Q1 to Q9 each implemented by a metal-oxide-semiconductor field-effect transistor (MOSFET), resistors R1 to R12, RA, and RB each a having fixed electric resistance value, a capacitor C1, a capacitor C2, the varistor V, a reactor L3 connected to the charging IC 3, a reactor L5 connected to the booster circuit 5, and a reactor L11 connected to the booster circuit 11. Each of the switch Q3, the switch Q4, the switch Q7, the switch Q8, and the switch Q9 is implemented by an N-channel MOSFET. Each of the switch Q1, the switch Q2, the switch Q5, and the switch Q6 is implemented by a P-channel MOSFET. Each of the switches Q1 to Q8 is switched between an ON state and an OFF state by controlling a potential of the gate terminal by the MCU 6.

In FIG. 12, various terminals are denoted by reference numerals in each IC except for the operational amplifier. A terminal VCC and a terminal VDD mounted on the chip each indicate a power supply terminal on a high potential side. A terminal VSS and a terminal GND mounted on the chip each indicate a low-potential-side (reference-potential-side) power supply terminal. In the electronic component formed into a chip, a difference between a potential of the power supply terminal on the high potential side and a potential of the power supply terminal on the low potential side is a power supply voltage (an operating voltage). The electronic component formed into a chip executes various functions by using the power supply voltage.

In FIG. 12, the terminal GND and the terminal VSS of each IC except for the operational amplifier are connected to the ground line. Further, the terminal GND of the charging terminal 1, a negative power supply terminal of the operational amplifier OP1, and a negative power supply terminal of the operational amplifier OP2 are connected to the ground line.

The battery connector 20D (see a vicinity of a left center part in FIG. 12) provided on the main substrate 20 includes a terminal BAT connected to each of a detection terminal SNS of the charging IC 3 and a charging terminal BAT of the charging IC 3; a terminal GND connected to the ground line of the main substrate 20; and a terminal TH3 connected to a terminal P25 of the MCU 6. The terminal BAT of the battery connector 20D is connected, by the lead wire 16, to a positive terminal of the power supply ba provided in the battery pack BP. The terminal TH3 of the battery connector 20D is connected, by the lead wire 16, to a positive terminal of a power supply thermistor th3 provided in the battery pack BP. The terminal GND of the battery connector 20D is connected, by lead wire 16, to a negative terminal of the power supply ba and a negative terminal of the power supply thermistor th3.

The OLED connector 20C (see a vicinity of a lower left part in FIG. 12) provided on the main substrate 20 includes a terminal VCC_R connected to an output terminal VOUT of the booster circuit 5; a terminal VDD connected to an output terminal OUT of the LDO 4; a terminal RSTB connected to a terminal P24 of the MCU 6; a communication terminal T3 connected to a communication terminal P28 of the MCU 6 by a signal line SL; and a terminal VSS connected to the ground line of the main substrate 20.

The terminal VCC_R of the OLED connector 20C is connected to a drive voltage supply terminal of the OLED panel 17 by the OLED FPC 25. The terminal VDD of the OLED connector 20C is connected, by the OLED FPC 25, to a power supply terminal of a control IC for controlling the OLED panel 17. A voltage to be supplied to the drive voltage supply terminal of the OLED panel 17 is, for example, about 15 V, which is higher than a voltage to be supplied to the power supply terminal of the control IC of the OLED panel 17. The terminal VSS of the OLED connector 20C is connected, by the OLED FPC 25, to respective ground terminals of the OLED panel 17 and the control IC of the OLED panel 17. The terminal RSTB of the OLED connector 20C is connected, by the OLED FPC 25, to a terminal for restarting the control IC of the OLED panel 17.

The signal line SL connected to the communication terminal T3 of the OLED connector 20C is also connected to a communication terminal T3 of the charging IC 3. Through the signal line SL, the MCU 6 can communicate with the charging IC 3 and the control IC of the OLED panel 17. The signal line SL is used for serial communication, and a plurality of signal lines such as a data line for data transmission and a clock line for synchronization are actually required. It should be noted that, in FIG. 12, the signal line SL is shown as one signal line for simplification. The communication between the MCU 6 and the charging IC 3 and the control IC of the OLED panel 17 may be performed by parallel communication instead of serial communication.

The debug connector 20E (see a vicinity of a lower left part in FIG. 12) provided on the main substrate 20 includes a terminal VMCU connected to the output terminal OUT of the LDO 4; a terminal T1 (one terminal is shown in the drawing, but there are two terminals actually) connected to a communication terminal P23 of the MCU 6; a terminal T2 (one terminal is shown in the drawing, but there are two terminals actually) connected to a communication terminal P22 of the MCU 6; a terminal NRST connected to a terminal P27 of the MCU 6; and a terminal GND connected to the ground line of the main substrate 20. The terminal NRST is also connected to a drain terminal of the switch Q9 whose gate terminal is connected to a drain terminal of the switch Q7 and whose source terminal is connected to the ground line. The debug connector 20E is not used in a normal use state of the aerosol generation device 200, and is used by being connected to a computer prepared by a manufacturer or a seller only when maintenance such as rewriting of information (including a program) stored in the MCU 6 is necessary.

The main connector 20A (see a vicinity of a right center part in FIG. 12) provided on the main substrate 20 includes a terminal PUFF connected to a terminal P19 of the MCU 6; a terminal LED connected to a drain terminal of a switch Q8 whose gate terminal is connected to a terminal P20 of the MCU 6 and whose source terminal is connected to the ground line; a terminal VIB connected to an output terminal OUT of the LSW 7; a terminal VOTG connected to a booster output terminal RN of the charging IC 3; a terminal VMCU connected to the output terminal OUT of the LDO 4 via a resistor R5; a terminal GND connected to the ground line; a terminal KEY connected to the output terminal OUT of the LDO 4 via a voltage dividing circuit including a resistor R4 and a resistor R3 connected in series to the resistor R4; a terminal HT1 (P1) connected to a drain terminal of the switch Q1 whose gate terminal is connected to a terminal P12 of the MCU 6 and whose source terminal is connected to an output terminal VOUT of the booster circuit 11; a terminal HT1 (P2) connected to a drain terminal of the switch Q2 whose gate terminal is connected to a terminal P13 of the MCU 6 and whose source terminal is connected to the output terminal VOUT of the booster circuit 11 and a drain terminal of the switch Q4 whose gate terminal is connected to a terminal P17 of the MCU 6 and whose source terminal is connected to the ground line; and a terminal HT1 (P3) connected to a drain terminal of the switch Q3 whose gate terminal is connected to a terminal P18 of the MCU 6 and whose source terminal is connected to the ground line.

The terminal HT1 (P1) of the main connector 20A is connected, by the main FPC 23, to the input-side contact point P1 connected to the pogo pin p1. The terminal HT1 (P2) of the main connector 20A is connected, by the main FPC 23, to the input-side contact point P2 connected to the pogo pin p2. The terminal HT1 (P3) of the main connector 20A is connected, by the main FPC 23, to the input-side contact point P3 connected to the pogo pin p3. The terminal KEY of the main connector 20A is connected, by a wiring of the main FPC 23, to one end of the switch BT mounted on the main FPC 23. The other end of the switch BT is connected to a ground line of the main FPC 23.

The heater connector 20B (see a vicinity of an upper right part in FIG. 12) provided on the main substrate 20 includes a first thermistor terminal TH1 connected, via a wiring of the heater FPC 24, to a positive terminal of a first thermistor th1 mounted on the heater FPC 24; a second thermistor terminal TH2 connected, via a wiring of the heater FPC 24, to a positive terminal of a second thermistor th2 mounted on the heater FPC 24; a sheet heater terminal HT2 connected, via a wiring of the heater FPC 24, to a positive terminal of the sheet heater HTR formed by a conductive pattern of the heater FPC 24; and a terminal GND connected to the ground line of the main substrate 20. The heater FPC 24 is provided with wirings connected to a negative terminal of the first thermistor th1, a negative terminal of the second thermistor th2, and a negative terminal of the sheet heater HTR, and the wirings are connected to the terminal GND of the heater connector 20B. The sheet heater terminal HT2 is connected to a drain terminal of the switch Q5 whose gate terminal is connected to a terminal P11 of the MCU 6 and whose source terminal is connected to the output terminal VOUT of the booster circuit 11.

The puff sensor connector 21A connected to the terminal group 15A of the inhalation sensor 15, the connector 21B connected to the main FPC 23, the vibration motor connector 21C connected to the vibration motor 13, the LED 21D, the varistor V, and the capacitor C2 are mounted on the puff sensor substrate 21 (see a vicinity of a lower center part in FIG. 12).

The connector 21B of the puff sensor substrate 21 includes terminals (a terminal PUFF, a terminal LED, a terminal VIB, a terminal VOTG, a terminal VMCU, and a terminal GND) connected by wirings formed on the main FPC 23 to the terminal PUFF, the terminal LED, the terminal VIB, the terminal VOTG, the terminal VMCU, and the terminal GND of the main connector 20A respectively. As described above, the main FPC 23 is provided with the switch BT connected between the terminal KEY of the main connector 20A and the ground line. When the switch BT is pressed down, the terminal KEY is connected to the ground line of the main FPC 23, and a potential of the terminal KEY gets to a ground potential. On the other hand, in a state where the switch BT is not pressed down, the terminal KEY is not connected to the ground line of the main FPC 23, and the potential of the terminal KEY is undefined.

The puff sensor connector 21A of the puff sensor substrate 21 includes a terminal GATE connected to the output terminal of the inhalation sensor 15, a terminal GND connected to the ground terminal of the inhalation sensor 15, and a terminal VDD connected to the power supply terminal of the inhalation sensor 15. The terminal GATE of the puff sensor connector 21A is connected to the terminal PUFF of the connector 21B. The terminal VDD of the puff sensor connector 21A is connected to the terminal VMCU of the connector 21B. The terminal GND of the puff sensor connector 21A is connected to the terminal GND of the connector 21B. One end of the varistor V is connected to a connection line between the terminal GATE of the puff sensor connector 21A and the terminal PUFF of the connector 21B, and the other end of the varistor V is connected to the ground line. Even when a large voltage is input to the terminal GATE from an inhalation sensor 15 side, the varistor V can prevent the voltage from being input to other components of the puff sensor substrate 21 or the MCU 6. One end of the capacitor C2 is connected to a connection line between the terminal VDD of the puff sensor connector 21A and the terminal VMCU of the connector 21B, and the other end of the capacitor C2 is connected to the ground line. Even when an unstable voltage is input to the terminal VDD of the puff sensor connector 21A from a main substrate 20 side via the capacitor C2, a voltage smoothed by the capacitor C2 can be input to the inhalation sensor 15.

The vibration motor connector 21C of the puff sensor substrate 21 includes a positive terminal connected to the terminal VIB of the connector 21B and a negative terminal connected to the ground line. The vibration motor 13 is connected to the positive terminal and the negative terminal.

The LED 21D of the puff sensor substrate 21 has an anode connected to the terminal VOTG of the connector 21B and a cathode connected to the terminal LED of the connector 21B.

The charging terminal 1 on an upper left part in FIG. 12 includes four terminals GND and four power supply input terminals BUS. Each power supply input terminal BUS of the charging terminal 1 is connected in parallel to an input terminal VIN of the protection IC 2. In a state where a USB plug is connected to the charging terminal 1 and a USB cable including the USB plug is connected to an external power supply, that is, in a state where the USB connection is established, a USB voltage V_{USB} is input to the input terminal VIN of the protection IC 2 via the power supply input terminal BUS of the charging terminal 1.

The protection IC 2 adjusts the USB voltage V_{USB} input to the input terminal VIN, and outputs a bus voltage V_{BUS} of a predetermined value (hereinafter, for example, 5.0 V) from an output terminal OUT. The charging IC 3, a voltage dividing circuit implemented by a series circuit including a resistor R1 and a resistor R2, and a switch Q7 are connected in parallel to the output terminal OUT of the protection IC 2. Specifically, the output terminal OUT of the protection IC 2 is connected to one end of the resistor R2 constituting the voltage dividing circuit, an input terminal VBUS of the charging IC 3, and the drain terminal of the switch Q7 whose gate terminal is connected to a terminal P21 of the MCU 6 and whose source terminal is connected to the ground line. One end of the resistor R1 is connected to the other end of the resistor R2, and the other end of the resistor R1 is connected to the ground line. A node connecting the resistor R1 and the resistor R2 is connected to a terminal P2 of the MCU 6. The protection IC 2 outputs the bus voltage V_{BUS} from the output terminal OUT in a state where a low level signal is input from the MCU 6 to a negative logic enable terminal CE( ), and stops outputting the bus voltage V_{BUS} from the output terminal OUT in a state where a high level signal is input from the MCU 6 to the enable terminal CE( ).

The charging IC 3 has a charging function of charging the power supply ba based on the bus voltage V_{BUS} input to the input terminal VBUS. The charging IC 3 acquires a charging current and a charging voltage of the power supply ba by a detection terminal SNS, and performs a charging control on the power supply ba (a control on power supply from the charging terminal BAT to the power supply ba) based on the charging current and the charging voltage. Further, the charging IC 3 acquires temperature information of the power supply ba, that is acquired by the MCU 6 from the electric power supply thermistor th3 via the terminal P25, from the MCU 6 by serial communication using the signal line SL, and uses the temperature information for the charging control.

The charging IC 3 has a first function of generating a system power supply voltage V_{SYS} from a voltage of the power supply ba input to the charging terminal BAT (hereinafter, referred to as a power supply voltage V_{BAT}) and outputting the system power supply voltage V_{SYS} from an output terminal SYS, a second function of generating the system power supply voltage V_{SYS} from the bus voltage V_{BUS} input to the input terminal VBUS and outputting the system power supply voltage V_{SYS} from the output terminal SYS, and a third function of outputting, from a booster output terminal RN, an OTG voltage V_{OTG} (for example, a voltage of 5 V) obtained by boosting the power supply voltage V_{BAT} input to the charging terminal BAT. The second function is enabled only in a state where the USB connection is established. As described above, the system power supply voltage V_{SYS} and the OTG voltage V_{OTG} are in a normal state where the power supply ba can supply electric power to the charging IC 3, and if the charging IC 3 is operating normally, output from the charging IC 3 is constantly possible.

One end of the reactor L3 is connected to a switching terminal SW of the charging IC 3. The other end of the reactor L3 is connected to the output terminal SYS of the charging IC 3. The charging IC 3 includes a negative logic enable terminal CE( ), and the enable terminal CE( ) is connected to a terminal P1 of the MCU 6. When a high level signal is input to the terminal P2 by establishing the USB connection, the MCU 6 controls a potential of the terminal P1 to get to a low level, and thereby charging control of the charging IC 3 on the power supply ba is permitted and the second function is enabled.

The charging IC 3 further includes a negative logic terminal QON( ). The terminal QON( ) is connected to a node N2 connecting the resistor R3 and the resistor R4, and the node N2 is connected to the terminal P21 of the MCU 6. When a low level signal is input to the terminal QON( ), the charging IC 3 stops the voltage output from the output terminal SYS.

The LDO 4, the booster circuit 5, and the booster circuit 11 are connected in parallel to the output terminal SYS of the charging IC 3. Specifically, the output terminal SYS of the charging IC 3 is connected to a control terminal CTL and an input terminal IN of the LDO 4, an input terminal VIN of the booster circuit 5, and an input terminal VIN of the booster circuit 11. The OTG voltage V_{OTG} output from the booster output terminal RN of the charging IC 3 is supplied to the anode of the LED 21D via the terminal VOTG of the main connector 20A and the terminal VOTG of the connector 21B. A cathode of the LED 21D is connected to ground via the terminal LED of the connector 21B, the terminal LED of the main connector 20A, and the switch Q8. Therefore, by the MCU 6 performing an ON/OFF control of the switch Q8, a lighting control on the LED 21D using the OTG voltage V_{OTG} can be performed.

The booster circuit 5 includes a switching terminal SW, a positive logic enable terminal EN connected to a terminal P26 of the MCU 6, an output terminal VOUT, and a terminal GND. One end of the reactor L5 is connected to the switching terminal SW of the booster circuit 5. The other end of the reactor L5 is connected to the input terminal VIN of the booster circuit 5. The booster circuit 5 performs an ON/OFF control of a built-in transistor connected to the switching terminal SW, thereby boosting a voltage input to the switching terminal SW via the reactor L5 and outputting the boosted voltage from the output terminal VOUT. An OLED voltage V_{OLED} output from the output terminal VOUT of the booster circuit 5 is a sufficiently high voltage suitable for driving the OLED panel 17, and is a voltage of 15 V as an example. The input terminal VIN of the booster circuit 5 constitutes a high-potential-side power supply terminal of the booster circuit 5. The booster circuit 5 outputs the OLED voltage V_{OLED} when a signal input from the terminal P26 of the MCU 6 to the enable terminal EN gets to a high level, and stops outputting the OLED voltage V_{OLED} when the signal input from the terminal P26 of the MCU 6 to the enable terminal EN gets to a low level. In this manner, the OLED panel 17 is driven and controlled by the MCU 6.

The booster circuit 11 includes an input terminal VIN, a switching terminal SW, an output terminal VOUT, a positive logic enable terminal EN, and a terminal GND. One end of the reactor L11 is connected to the switching terminal SW of the booster circuit 11. The other end of the reactor L11 is connected to the input terminal VIN of the booster circuit 11. The booster circuit 11 performs an ON/OFF control of a built-in transistor connected to the switching terminal SW, thereby boosting a voltage input to the switching terminal SW via the reactor L11 and outputting the boosted voltage from the output terminal VOUT. A heating voltage V_{HEAT} output from the output terminal VOUT of the booster circuit 11 is, for example, a voltage of 4 V The input terminal VIN of the booster circuit 11 constitutes a high-potential-side power supply terminal of the booster circuit 11. The booster circuit 11 outputs the heating voltage V_{HEAT} when a signal input from an output terminal Y of an AND gate 10 to be described later to the enable terminal EN gets to a high level, and stops outputting the heating voltage V_{HEAT} when the signal input to the enable terminal EN gets to a low level.

The capacitor C1, a voltage dividing circuit implemented by a series circuit including a resistor R7 and a resistor R6, the multiplexer 8, the switch Q1, the switch Q2, and the switch Q5 are connected in parallel to the output terminal VOUT of the booster circuit 11. Specifically, the output terminal VOUT of the booster circuit 11 is connected to one end of the capacitor C1 the other end of which is connected to the ground line; an input terminal of the voltage dividing circuit including the resistor R6 connected to the ground line and the resistor R7 connected in series to the resistor R6 (a terminal opposite to a resistor R6 side of the resistor R7); a terminal VCC of the multiplexer 8; a source terminal of the switch Q1; a source terminal of the switch Q2; and a source terminal of the switch Q5.

A resistor RA having an electric resistance value Ra is connected in parallel to the switch Q1. A resistor RB having an electric resistance value Rb is connected in parallel to the switch Q2.

The multiplexer 8 includes an input terminal B0, an input terminal B1, an output terminal A, and a select terminal SE. The multiplexer 8 switches between a state where the input terminal B0 and the output terminal A are connected and a state where the input terminal B1 and the output terminal A are connected according to a control signal input from a terminal P15 of the MCU 6 to the select terminal SE.

The input terminal B0 of the multiplexer 8 is connected to a line connecting the switch Q1 and the terminal HT1 (P1). The input terminal B1 of the multiplexer 8 is connected to a line connecting the switch Q2 and the terminal HT1 (P2). The output terminal A of the multiplexer 8 is connected to a noninverting input terminal of the operational amplifier OP1. An inverting input terminal of the operational amplifier OP1 is connected to a node connecting the resistor R7 and the resistor R6. An output terminal of the operational amplifier OP1 is connected to a terminal P14 of the MCU 6.

In a state where a signal input to the control terminal CTL is at a high level (in other words, a state where the system power supply voltage V_{SYS} is output from the output terminal SYS of the charging IC 3), the LDO 4 converts a voltage input to the input terminal VIN (that is, the system power supply voltage V_{SYS}) and outputs the obtained voltage as a system power supply voltage V_{MCU} from the output terminal OUT. The system power supply voltage V_{SYS} is a value in a range of 3.5 V to 4.2 V as an example, and the system power supply voltage V_{MCU} is 3.1 V as an example.

The control IC of the OLED panel 17, the MCU 6, the LSW 7, the inhalation sensor 15, a series circuit including the resistor R3, the resistor R4, and the switch BT, and the debug connector 20E are connected in parallel to the output terminal OUT of the LDO 4. Specifically, the output terminal OUT of the LDO 4 is connected to the terminal VDD of the OLED connector 20C, a power supply terminal VDD of the MCU 6, an input terminal VIN of the LSW 7, one end (a node N1 in the drawing) of the resistor R5 the other end of which is connected to a terminal VMCU of the main connector 20A, an input end (the node N1 in the drawing) of the voltage dividing circuit including the resistor R4 and the resistor R3, and the terminal VMCU of the debug connector 20E.

Further, the output terminal OUT of the LDO 4 is connected to a source terminal of the switch Q6 whose gate terminal is connected to a terminal P4 of the MCU 6. A terminal VCC of the AND gate 10, a terminal VCC of the FF9, one end of a resistor R11, one end of a resistor R12, a positive power supply terminal of the operational amplifier OP2, one end of a resistor R8, one end of a resistor R9, and a positive power supply terminal of the operational amplifier OP1 are connected in parallel to a drain terminal of the switch Q6.

The other end of the resistor R12 is connected to the second thermistor terminal TH2, and a series circuit including the resistor R12 and the second thermistor th2 connected to the second thermistor terminal TH2 constitutes a voltage dividing circuit to which the system power supply voltage V_{MCU} is applied. An output of the voltage dividing circuit corresponds to an electric resistance value (in other words, temperature) of the second thermistor th2, and is input to the terminal P8 of the MCU 6. Thus, the MCU 6 can acquire the temperature of the second thermistor th2. In the present embodiment, as the second thermistor th2, a thermistor having the NTC characteristic in which the resistance value decreases as the temperature increases is used, but a thermistor having the PTC characteristic in which the resistance value increases as the temperature increases may be used.

One end of a resistor R10 is connected to the other end of the resistor R9, and the other end of the resistor R10 is connected to the ground line. A series circuit including the resistor R9 and the resistor R10 constitutes a voltage dividing circuit to which the system power supply voltage V_{MCU} is applied. An output of the voltage dividing circuit is connected to a inverting input terminal of the operational amplifier OP2, and a fixed voltage value is input to the inverting input terminal. The other end of the resistor R8 is connected to a noninverting input terminal of the operational amplifier OP2.

The other end of the resistor R8 is further connected to the first thermistor terminal TH1 and a terminal P9 of the MCU 6. A series circuit including the resistor R8 and the first thermistor th1 connected to the first thermistor terminal TH1 constitutes a voltage dividing circuit to which the system power supply voltage V_{MCU} is applied. An output of the voltage dividing circuit corresponds to an electric resistance value (in other words, temperature) of the first thermistor th1, and is input to the terminal P9 of the MCU 6. Accordingly, the MCU 6 can acquire the temperature of the first thermistor th1 (in other words, a temperature of the sheet heater HTR). Further, an output of the voltage dividing circuit is also input to the noninverting input terminal of the operational amplifier OP2. In the present embodiment, as the first thermistor th1, a thermistor having the NTC characteristic in which the resistance value decreases as the temperature increases is used. Therefore, an output of the operational amplifier OP2 gets to a low level when the temperature of the first thermistor th1 (the temperature of the sheet heater HTR) increases and the temperature is equal to or higher than a threshold THD1. In other words, as long as the temperature of the first thermistor th1 (the temperature of the sheet heater HTR) is in a normal range, the output of the operational amplifier OP2 is at a high level.

In a case where a thermistor having the PTC characteristic in which the resistance value increases as the temperature increases is used as the first thermistor th1, an output of the voltage dividing circuit including the first thermistor th1 and the resistor R8 may be connected to the inverting input terminal of the operational amplifier OP2, and an output of the voltage dividing circuit including the resistor R9 and the resistor R10 may be connected to the noninverting input terminal of the operational amplifier OP2. In this case, when the temperature of the first thermistor th1 (the temperature of the sheet heater HTR) increases and the temperature is equal to or higher than the threshold THD1, the output of the operational amplifier OP2 also gets to a low level.

An output terminal of the operational amplifier OP2 is connected to an input terminal D of the FF9. The other end of the resistor R11 and a negative logic clear terminal CLR( ) provided in the FF9 are connected to a node connecting the input terminal D of the FF9 and the output terminal of the operational amplifier OP2. That is, the input terminal D of the FF9, the clear terminal CLR( ) of the FF9, and the output terminal of the operational amplifier OP2 are pulled up to a supply line of the system power supply voltage V_{MCU} by the resistor R11.

The FF9 has a clock terminal CLK, the clock terminal CLK is connected to a terminal P7 of the MCU 6. The FF9 has an output terminal Q, and the output terminal Q is connected to an input terminal B of the AND gate 10. In a state where a clock signal is input from the MCU 6 to the clock terminal CLK and a high level signal is input to the clear terminal CLR( ), the FF9 holds data (high or low data) according to a level of a signal input to the input terminal D and outputs the held data from the output terminal Q. In a state where a clock signal is input from the MCU 6 to the clock terminal CLK and a low level signal is input to the clear terminal CLR( ), the FF9 performs reset processing of outputting the low level signal from the output terminal Q regardless of the held data. The reset processing is cancelled by re-inputting a clock signal to the clock terminal CLK in a state where a high level signal is input to the clear terminal CLR( ). That is, the supply of the clock signal to the clock terminal CLK is stopped in a state where a high level signal is input to the clear terminal CLR( ), and then the supply of the clock signal is resumed, thus cancelling the reset processing.

An input terminal A of the AND gate 10 is connected to a terminal P6 of the MCU 6. The output terminal Y of the AND gate 10 is connected to a positive logic enable terminal EN of the booster circuit 11. The AND gate 10 outputs a high level signal from the output terminal Y only in a state where both the signal input to the input terminal A and the signal input to the input terminal B are at a high level.

When a control signal is input to a control terminal CTL from a terminal P10 of the MCU 6, the LSW 7 outputs, from the output terminal OUT, the system power supply voltage V_{MCU} input to the input terminal VIN. The output terminal OUT of the LSW 7 is connected to the vibration motor 13 via the terminal VIB of the main substrate 20 and the terminal VIB of the puff sensor substrate 21. Therefore, when the MCU 6 inputs the control signal to the LSW 7, the vibration motor 13 can be operated using the system power supply voltage V_{MCU}.

### (Transition from Standby Mode to Heating Mode)

The power supply unit 100 has, as operation modes, a sleep mode in which power saving is achieved, a standby mode in which transition from the sleep mode is possible, and a heating mode in which transition from the standby mode is possible (a mode in which a liquid heater or the sheet heater HTR performs heating and aerosol is generated). When a specific operation (for example, a long-press operation) on the switch BT is detected in the sleep mode, the MCU 6 switches the operation mode to the standby mode. When a specific operation (for example, a short-press operation) on the switch BT is detected in the standby mode, the MCU 6 switches the operation mode to the heating mode.

### (Operation of Heating Mode)

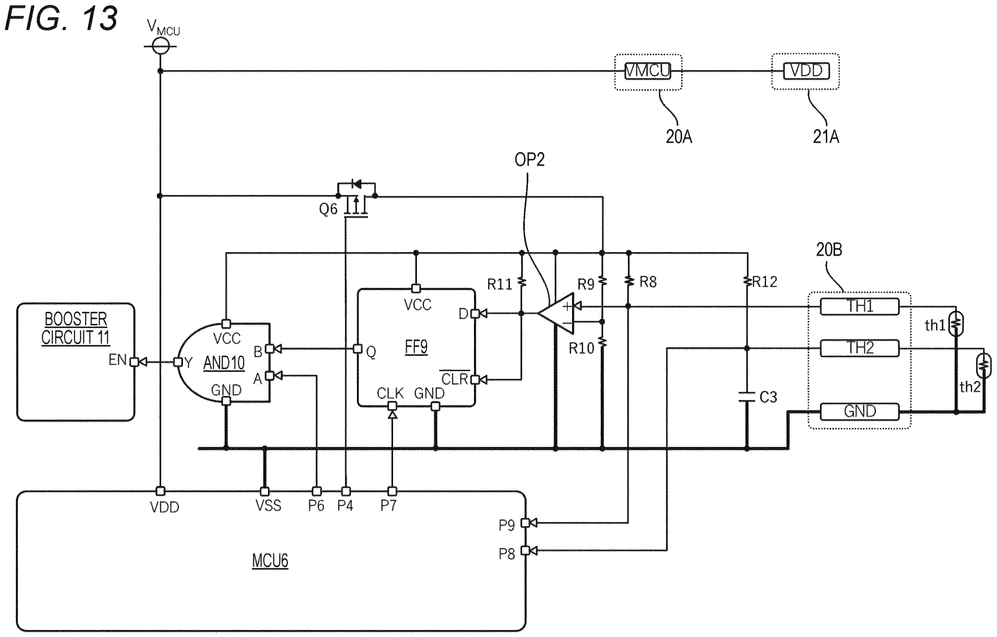

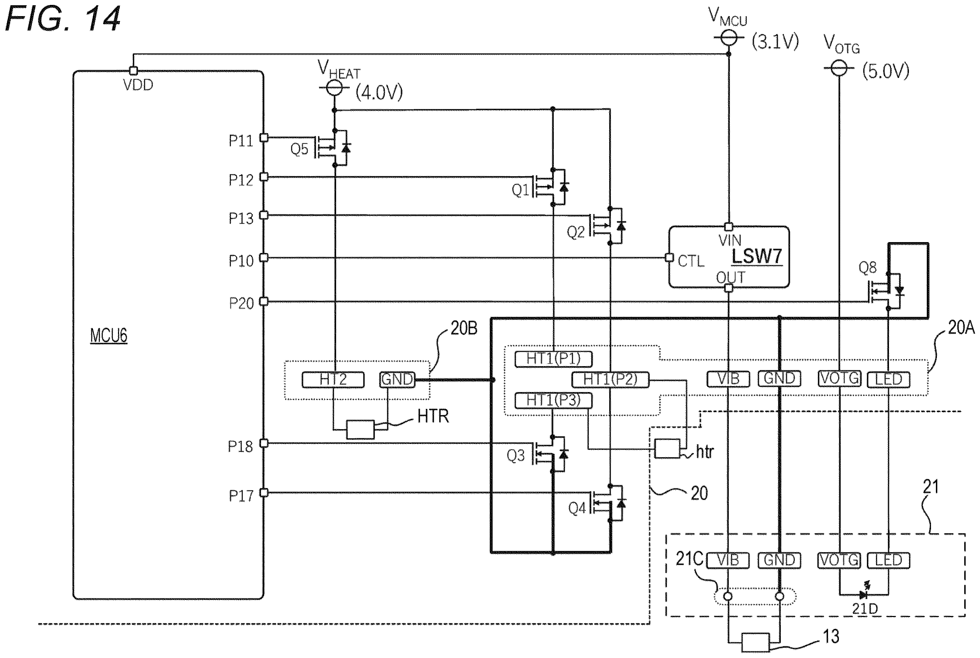

FIG. 13 is a circuit diagram showing electronic components related to an operation in the heating mode and extracted from the circuit shown in FIG. 12. In FIG. 13, a capacitor C3 not shown in FIG. 12 is additionally shown. FIG. 14 is a circuit diagram showing electronic components related to a heating control of the sheet heater HTR and a liquid heater, a driving control of the vibration motor 13, and a driving control of the LED 21D and extracted from the circuit shown in FIG. 12. Hereinafter, the operation in the heating mode will be described with reference to FIGS. 13 and 14.

When transitioning to the heating mode, the MCU 6 controls the switch Q6 shown in FIG. 13 to an ON state. Thus, the system power supply voltage V_{MCU} is supplied to the AND gate 10, the FF9, the resistor R11, the operational amplifier OP2, the resistor R11, the voltage dividing circuit including the resistor R9 and the resistor R10, the voltage dividing circuit including the resistor R8 and the first thermistor th1, the voltage dividing circuit including the resistor R12 and the second thermistor th2, and the operational amplifier OP1. Further, when transitioning to the heating mode, the MCU 6 controls a signal input from the terminal P6 to the input terminal A of the AND gate 10 to get to a high level. The MCU 6 starts inputting the clock signal to the clock terminal CLK of the FF9. In this state, as long as the temperature of the first thermistor th1 (the temperature of the sheet heater HTR) is in a normal range (less than the threshold THD1), the output of the operational amplifier OP2 is at a high level, as a result, the output of the FF9 is at a high level, and as a result, the output of the AND gate 10 is at a high level. Therefore, the booster circuit 11 starts outputting the heating voltage V_{HEAT}, and heating of the sheet heater HTR and the liquid heater is possible.

### (Determination of Connection Destination of Liquid Heater)

When the booster circuit 11 starts outputting the heating voltage V_{HEAT}, as shown in FIG. 14, electric power can be supplied to the sheet heater HTR connected to the sheet heater terminal HT2, and a liquid heater connected to any two of the terminals HT1 (P1) to the terminal HT1 (P3) (in FIG. 14, a liquid heater htr connected to the terminal HT1 (P1) and the terminal HT1 (P2) is shown). In this state, first, the MCU 6 determines, based on the output of the operational amplifier OP1 shown in FIG. 12, to which pair among the pogo pin p1, the pogo pin p2, and the pogo pin p3 the liquid heater is connected. The determination processing includes the following first step, second step, and third step.

### (First Step)

The MCU 6 performs a control to connect the input terminal B0 and the output terminal A of the multiplexer 8 in a state where only the switch Q4 among the switches Q1 to Q4 is controlled to an ON state. In this state, when it is assumed that an electric resistance value between the terminal HT1 (P1) and the terminal HT1 (P2) is Rx, a divided voltage value = V_{HEAT} * {Rx/(Ra + Rx)} is input to the noninverting input terminal of the operational amplifier OP1. In the operational amplifier OP1, the voltage input to the noninverting input terminal is compared with a value of a divided voltage value in a case where a liquid heater is connected between the terminal HT1 (P1) and the terminal HT1 (P2), and when a difference is small, the output of the operational amplifier OP1 gets to a low level. Therefore, when the output of the operational amplifier OP1 gets to a low level, the MCU 6 determines that the liquid heater is connected between the terminal HT1 (P1) and the terminal HT1 (P2).

### (Second Step)

When the output of the operational amplifier OP1 gets to a high level in the first step, the MCU 6 performs a control to connect the input terminal B0 and the output terminal A of the multiplexer 8 in a state where only the switch Q3 among the switches Q1 to Q4 is controlled to an ON state. In this state, when the liquid heater is connected between the terminal HT1 (P1) and the terminal HT1 (P3), the output of the operational amplifier OP1 gets to a low level. Therefore, when the output of the operational amplifier OP1 gets to a low level, the MCU 6 determines that the liquid heater is connected between the terminal HT1 (P1) and the terminal HT1 (P3).

### (Third Step)

When the output of the operational amplifier OP1 gets to a high level in the second step, the MCU 6 performs a control to connect the input terminal B1 and the output terminal A of the multiplexer 8 in a state where only the switch Q3 among the switches Q1 to Q4 is controlled to an ON state. In this state, when the liquid heater is connected between the terminal HT1 (P2) and the terminal HT1 (P3), the output of the operational amplifier OP1 gets to a low level. Therefore, when the output of the operational amplifier OP1 gets to a low level, the MCU 6 determines that the liquid heater is connected between the terminal HT1 (P2) and the terminal HT1 (P3).

When the output of the operational amplifier OP1 does not get to a low level in any of the first step to the third step, the MCU 6 issues an error notification.

### (Start of Heating Control)

When a level of the output of the inhalation sensor 15 is changed to a value corresponding to the inhalation performed by the user in a state where the determination processing is finished, the MCU 6 starts the heating control of the sheet heater HTR and the liquid heater. Specifically, the MCU 6 performs the heating control of the sheet heater HTR by performing an ON/OFF control (for example, a PWM control or a PFM control) of the switch Q5 shown in FIG. 14. At this time, the MCU 6 performs, based on the temperature of the second thermistor th2 (in other words, the temperature of the sheet heater HTR) acquired from the signal input to the terminal P8, the heating control of the sheet heater HTR such that the temperature of the sheet heater HTR converges to a target temperature. As the heating control, for example, a Proportional-Integral-Differential (PID) control is used.

In addition, when the liquid heater is connected between the terminal HT1 (P1) and the terminal HT1 (P2), the MCU 6 performs the heating control of the liquid heater by controlling the switch Q4 to an ON state, controlling the switch Q2 and the switch Q3 to an OFF state, and performing an ON/OFF control (for example, the PWM control or the PFM control) on the switch Q1 among the switches Q1 to Q4 shown in FIG. 14. When the liquid heater is connected between the terminal HT1 (P1) and the terminal HT1 (P3), the MCU 6 performs the heating control of the liquid heater by controlling the switch Q3 to an ON state, controlling the switch Q2 and the switch Q4 to an OFF state, and performing an ON/OFF control on the switch Q1 among the switches Q1 to Q4. When the liquid heater is connected between the terminal HT1 (P2) and the terminal HT1 (P3), the MCU 6 performs the heating control of the liquid heater by controlling the switch Q3 to an ON state, controlling the switch Q1 and the switch Q4 to an OFF state, and performing an ON/OFF control on the switch Q2 among the switches Q1 to Q4.

As shown in FIG. 13, the system power supply voltage V_{MCU} output from the LDO 4 is constantly supplied to the inhalation sensor 15 connected to the puff sensor connector 21A. Meanwhile, the system power supply voltage V_{MCU} is supplied, via the switch Q6, to the electronic components that need to operate only in the heating mode. With such a configuration, power consumption of the electronic components can be reduced in a mode other than the heating mode. Immediately after the system power supply voltage V_{MCU} is applied to the inhalation sensor 15, an operation of the inhalation sensor 15 may be unstable. Therefore, by constantly supplying the system power supply voltage V_{MCU} to the inhalation sensor 15, even when the inhalation is performed immediately after the transition to the heating mode, the inhalation operation can be detected with high accuracy by the inhalation sensor 15.

Further, in the present embodiment, the puff sensor substrate 21 on which the inhalation sensor 15 is mounted, and the main substrate 20 on which the MCU 6 which tends to be a noise source is mounted are disposed to be physically separated from each other. As a result, the inhalation sensor 15 that is constantly operated can be more stably operated. The switch BT, which tends to be an entrance of noise such as electrostatic electricity, is not mounted on the puff sensor substrate 21, and the switch BT is directly mounted on the main FPC 23. This also makes it possible to more stably operate the inhalation sensor 15 that is constantly operated. Further, since the switch BT is mounted on the flexible main FPC 23, a distance between the switch BT and the inhalation sensor 15 can be easily increased.

FIG. 14 shows the connectors (the main connector 20A and the heater connector 20B) electrically connected to the power supply ba; the LED 21D and the vibration motor 13 that are connected to the main connector 20A via a cable such as an FPC or a lead wire; the switch Q8 electrically connected to a low potential side of the main connector 20A and capable of opening and closing an electrical connection between the power supply ba and the LED 21D; and the LSW 7 electrically connected to a high potential side of the main connector 20A and capable of opening and closing an electrical connection between the power supply ba and the vibration motor 13.

Here, attention is focused on the LED 21D and the vibration motor 13 which are loads that receive power supply from the power supply ba. When vibrating, the vibration motor 13 may generate a counter-electromotive force (a reverse current flowing from a low potential side to a high potential side). In the present embodiment, a switch used for controlling the power supply to the vibration motor 13 is not a simple switch but the high-performance LSW 7 having a backflow prevention function. Accordingly, the counter-electromotive force and the reverse current generated in the vibration motor 13 can be prevented from being input to the MCU 6, and durability of the MCU 6 is improved.

Meanwhile, the LED 21D is driven at an operating voltage (specifically, the OTG voltage V_{OTG}) larger than an operating voltage (specifically, the system power supply voltage V_{MCU}) of the vibration motor 13, although there is no concern of the counter-electromotive force. This is because it is necessary to increase the operating voltage in order to increase luminance of the LED 21D. In the present embodiment, the switch Q8 for controlling power supply to the LED 21D is connected to a low potential side of the main connector 20A. Accordingly, even when the switch Q8 is short-circuited, the OTG voltage V_{OTG} larger than the system power supply voltage V_{MCU} can be prevented from being input from the switch Q8 to the MCU 6. As described above, since the switch Q8 is provided on the low potential side, the OTG voltage V_{OTG} can be set to a high value without being limited by the system power supply voltage V_{MCU}, and the luminance of the LED 21D can be effectively increased.

FIG. 14 further shows the sheet heater HTR connected to the heater connector 20B via a cable such as the FPC; the liquid heater (in the drawing, the liquid heater htr is described as an example) connected to the main connector 20A via a cable such as the FPC; the switch Q5 electrically connected to a high potential side of the heater connector 20B and capable of opening and closing an electrical connection between the power supply ba and the sheet heater HTR; the switch Q1 and the switch Q2 that are electrically connected to a high potential side of the main connector 20A and capable of opening and closing an electrical connection between the power supply ba and the liquid heater; and the switch Q3 and the switch Q4 that are electrically connected to a low potential side of the main connector 20A and capable of opening and closing an electrical connection between the power supply ba and the liquid heater.

Here, attention is focused on the sheet heater HTR and the liquid heater which are loads that receive power supply from the power supply ba. Since the liquid heater needs to atomize the aerosol source, it is required to supply a large amount of electric power per unit time. Meanwhile, since the sheet heater HTR only needs to be supplied with electric power to an extent that an amount of the flavor released from the flavor source is improved, the electric power required to be supplied per unit time is not larger than that of the liquid heater. Therefore, the switches Q1 to Q4 for controlling power supply to the liquid heater are more likely to be short-circuited than the switch Q5 for controlling power supply to the sheet heater HTR.

In the present embodiment, with respect to the liquid heater, the switch Q1 and the switch Q2 are connected to a high potential side (in other words, between the liquid heater and the power supply ba), and the switch Q3 and the switch Q4 are connected to a low potential side (in other words, between the liquid heater and the ground). Accordingly, even when one of a switch in the switch Q1 and the switch Q2 which is connected to the liquid heater and a switch in the switch Q3 and the switch Q4 which is connected to the liquid heater is short-circuited, a short-circuit current of the one switch can be prevented from being continuously supplied to the liquid heater by controlling the other switch to an OFF state. Thereby, safety of the power supply unit 100 can be improved. An electric resistance value Ra of the resistor RA connected in parallel to the switch Q1 and an electric resistance value Rb of the resistor RB connected in parallel to the switch Q2 are sufficiently high values. That is, it should be noted that the short-circuited current passing through the resistor RA and the resistor RB is not supplied to the liquid heater.

In the present embodiment, only the switch Q5 is connected to a high potential side with respect to the sheet heater HTR (in other words, between the sheet heater HTR and the power supply ba). As described above, since the switch Q5 is unlikely to be short-circuited, safety can be ensured even without providing another switch between the sheet heater HTR and the ground. The temperature of the sheet heater HTR is controlled by a protection circuit to be described later so as not to become excessively high. Therefore, even if the switch Q5 is short-circuited, the sheet heater HTR can be prevented from being continuously heated due to a function of the protection circuit. From this viewpoint, safety can also be ensured even without providing another switch between the sheet heater HTR and the ground. As described above, since only one switch connected to the sheet heater HTR is used, the number of components of the power supply unit 100 can be reduced, and a manufacturing cost of the power supply unit 100 can be reduced.

### (Overheating Protection of Heater)

In the power supply unit 100, in the heating mode, electric resistance values of the resistor R8, the resistor R9, and the resistor R10 are determined such that the output of the operational amplifier OP2 gets to a low level when the temperature of the first thermistor th1 is equal to or higher than the threshold THD1. When the temperature of the first thermistor th1 is equal to or higher than the threshold THD1 and the output of the operational amplifier OP2 gets to a low level, a low level signal is input to the clear terminal CLR( ) of the FF9. As a result, since the output of the FF9 is forcibly changed to a low level by canceling the data held by the FF9, the output of the AND gate 10 also gets to a low level, and the booster circuit 11 stops outputting the heating voltage V_{HEAT}. That is, the output of the operational amplifier OP2 getting to a low level means that the signal input to the enable terminal EN of the booster circuit 11 gets to a low level.

When the control on power supply from the MCU 6 to the sheet heater HTR functions normally, the temperature of the first thermistor th1 is not equal to or higher than the threshold THD1 in principle. That is, when the temperature of the first thermistor th1 is equal to or higher than the threshold THD1, it means that there is a high possibility that some failure occurs in the circuit (specifically, the switch Q5) that supplies electric power to the sheet heater HTR or the MCU 6.

In the present embodiment, a low level signal output from the operational amplifier OP2 does not control the MCU 6 and the switch Q5, but control the booster circuit 11 that outputs the heating voltage V_{HEAT} so as to stop the heating of the sheet heater HTR. As described above, since the output signal of the operational amplifier OP2 is input to the booster circuit 11 capable of reliably stopping the power supply to the sheet heater HTR, safety when the sheet heater HTR reaches a high temperature can be enhanced. For example, when the temperature of the first thermistor th1 is equal to or higher than the threshold THD1 due to freezing of the MCU 6 or short-circuiting of the switch Q5, the MCU 6 or the switch Q5 cannot be controlled. Even in such a case, by inputting a low level signal from the operational amplifier OP2 to the enable terminal EN of the booster circuit 11, the power supply to the sheet heater HTR can be reliably stopped.

Further, as a method of stopping the output of the heating voltage V_{HEAT} from the booster circuit 11, a method of inputting a high level signal to the enable terminal CE( ) of the charging IC that generates the system power supply voltage V_{SYS} to be input to the booster circuit 11 is also conceivable. In contrast to this method, according to the configuration in which the output of the operational amplifier OP2 can be input to the enable terminal EN of the booster circuit 11, there is an advantage that the circuit configuration can be simplified and the manufacturing cost can be reduced.

In order to return the output of the FF9 to a high level, it is necessary for the MCU 6 to re-input a clock signal to the clock terminal CLK of the FF9 (in other words, restart the FF9). That is, even if the temperature of the first thermistor th1 returns to less than the threshold THD1 after the output from the booster circuit 11 is stopped, the output from the booster circuit 11 is not resumed unless the MCU 6 performs the restart processing of the FF9.

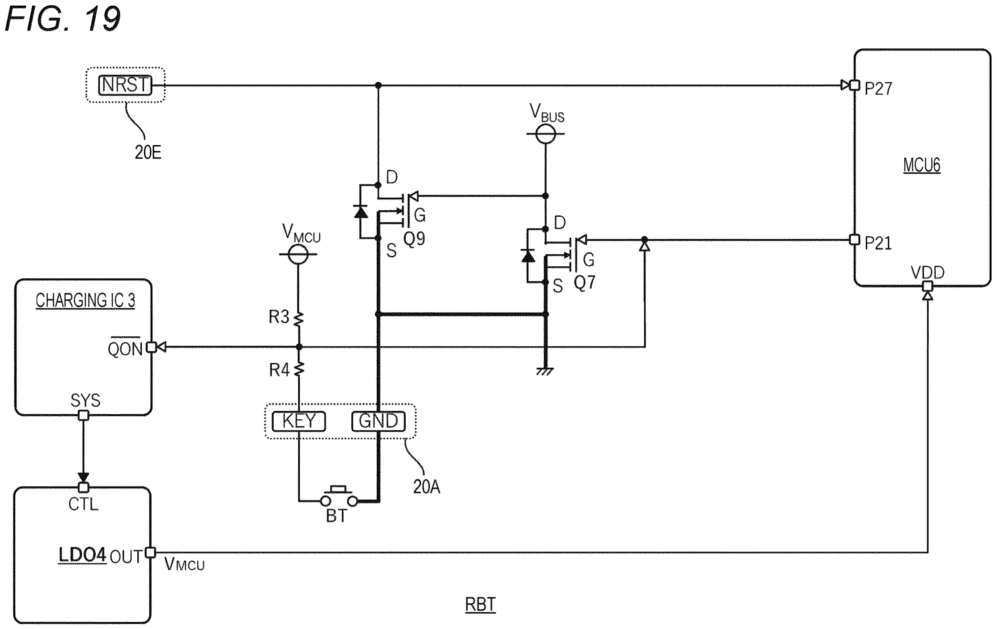

It is assumed that a cause of the temperature of the first thermistor th1 becoming equal to or higher than the threshold THD1 is freezing of the MCU 6. In this case, a high level signal is continuously input to the input terminal A of the AND gate 10, and a clock signal is continuously input to the FF9. Although details will be described later, the aerosol generation device 200 is provided with a restart circuit RBT (see FIG. 19) capable of restarting (resetting) the MCU 6 by an operation on the switch BT from the user. When a cause of the protection circuit functioning is freezing of the MCU 6, the MCU 6 is restarted by the user. When the MCU 6 is restarted, the FF9 is restarted. When the MCU 6 is restarted, the signal input to the input terminal A of the AND gate 10 gets to a low level. Further, since the switch Q6 is in an OFF state at a timing when the MCU 6 is restarted, a potential of the signal of the input terminal B of the AND gate 10 is undefined. Therefore, the output from the booster circuit 11 is not resumed just by restarting the MCU 6. After the MCU 6 is restarted, the operation mode is transitioned to the heating mode by a user operation, and thus the signal input to the input terminal A of the AND gate 10 gets to a high level. Further, by setting the switch Q6 to an ON state, the signal input to the input terminal B of the AND gate 10 gets to a high level. Accordingly, the output from the booster circuit 11 is resumed.

As described above, the MCU 6 controls the restart of the output from the booster circuit 11 (controls the restart of the output after an intention of the user is reflected), and thereby the heating of the sheet heater HTR can be prevented from being restarted against the intention of the user and safety and convenience can be improved.

As described above, the AND gate 10, the FF9, and the operational amplifier OP2 constitute a protection circuit for stopping power supply to the sheet heater HTR to protect the sheet heater HTR when the sheet heater HTR reaches a high temperature. The protection circuit can autonomously stop the output from the booster circuit 11 according to the temperature of the first thermistor th1 instead of receiving a command for enabling the booster circuit 11 from the MCU 6, in other words, even when a high level signal is input to the input terminal A of the AND gate 10 and a clock signal is input to the clock terminal CLK of the FF9. Accordingly, even when an obstacle such as freezing occurs in the MCU 6, an emergency stop of the heating of the sheet heater HTR or the liquid heater can be executed, and thus safety of the aerosol generation device 200 can be improved.

When it is determined that the temperature of the second thermistor th2 acquired based on the signal input to the terminal P8 is equal to or higher than a threshold THD2 (this value is smaller than the threshold THD1), the MCU 6 sets the signal input to the input terminal A of the AND gate 10 to a low level. Accordingly, the output of the AND gate 10 gets to a low level, and the booster circuit 11 stops outputting the heating voltage V_{HEAT}. As described above, when the MCU 6 is operating normally, the output from the booster circuit 11 can also be stopped by a command from the MCU 6. Accordingly, for example, even when the first thermistor th1 is not operating normally, the output from the booster circuit 11 can be stopped in response to a command from the MCU 6 to improve safety. The threshold THD2 is smaller than the threshold THD1. Therefore, if the MCU 6 is operating normally, when the temperature of the sheet heater HTR is high, the MCU 6 can stop the output from the booster circuit 11 before the protection circuit, and the safety can be further improved.

In the present embodiment, the MCU 6 can acquire the temperature of the first thermistor th1 from the signal input to the terminal P9. Therefore, the MCU 6 determines whether the temperature of the second thermistor th2 can be normally acquired and when the temperature of the second thermistor th2 cannot be normally acquired, the MCU 6 preferably controls the heating of the sheet heater HTR based on the temperature of the first thermistor th1 such that the temperature of the sheet heater HTR converges to the target temperature. Accordingly, even when some abnormality occurs in the second thermistor th2, the heating control of the sheet heater HTR can be executed based on the first thermistor th1. Whether the temperature of the second thermistor th2 can be normally acquired can be determined by determining whether the signal input to the terminal P8 indicates an abnormal value or whether the signal can be acquired.

However, basically, the MCU 6 executes the heating control of the sheet heater HTR based on the temperature of the second thermistor th2. Therefore, the second thermistor th2 is preferably disposed at a position where the temperature of the sheet heater HTR can be reflected more accurately. Meanwhile, the first thermistor th1 is mainly used to stop the output from the booster circuit 11 by the protection circuit when the sheet heater HTR reaches a high temperature. Therefore, in order to reliably detect a high temperature state of the sheet heater HTR, the first thermistor th1 is preferably disposed at a position where the sheet heater HTR is likely to reach a high temperature. A detailed configuration of the heater FPC 24 on which the first thermistor th1 and the second thermistor th2 are mounted will be described later.

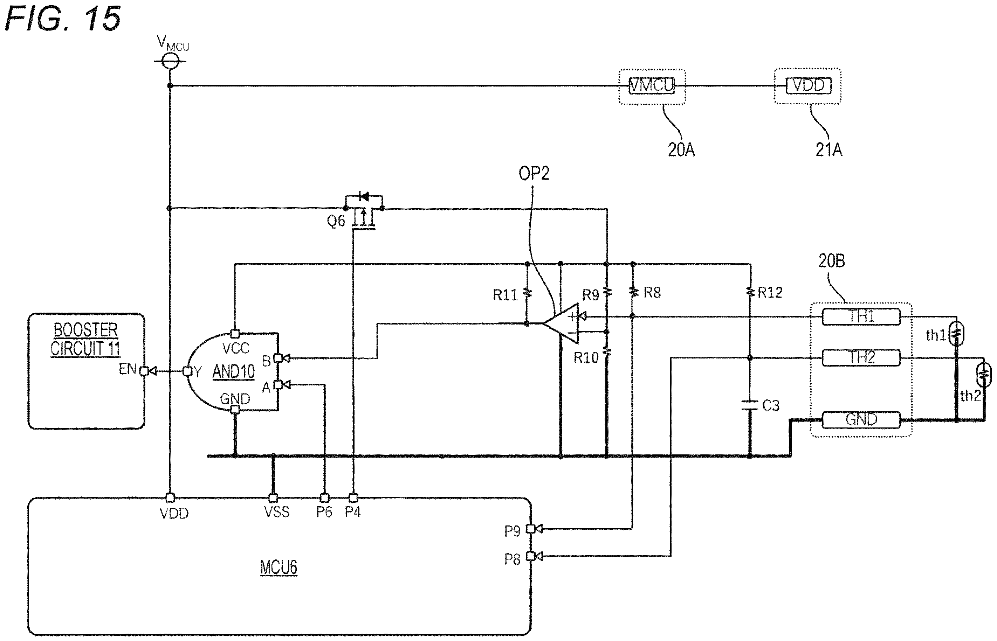

In the above-described protection circuit, the FF9 is not essential and may be omitted. FIG. 15 is a circuit diagram corresponding to FIG. 13 in a case where the FF9 is omitted. In the case where the FF9 is omitted, the output terminal of the operational amplifier OP2 may be connected to the input terminal B of the AND gate 10, as shown in FIG. 15. In the configuration shown in FIG. 15, when the temperature of the first thermistor th1 is equal to or higher than the threshold THD1 and the output of the operational amplifier OP2 gets to a low level, the output of the AND gate 10 gets to a low level. Accordingly, when the temperature of the sheet heater HTR is high, the output from the booster circuit 11 can be stopped. According to the configuration shown in FIG. 15, since the FF9 can be omitted, the power supply unit 100 can be reduced in size, weight, and power saving.

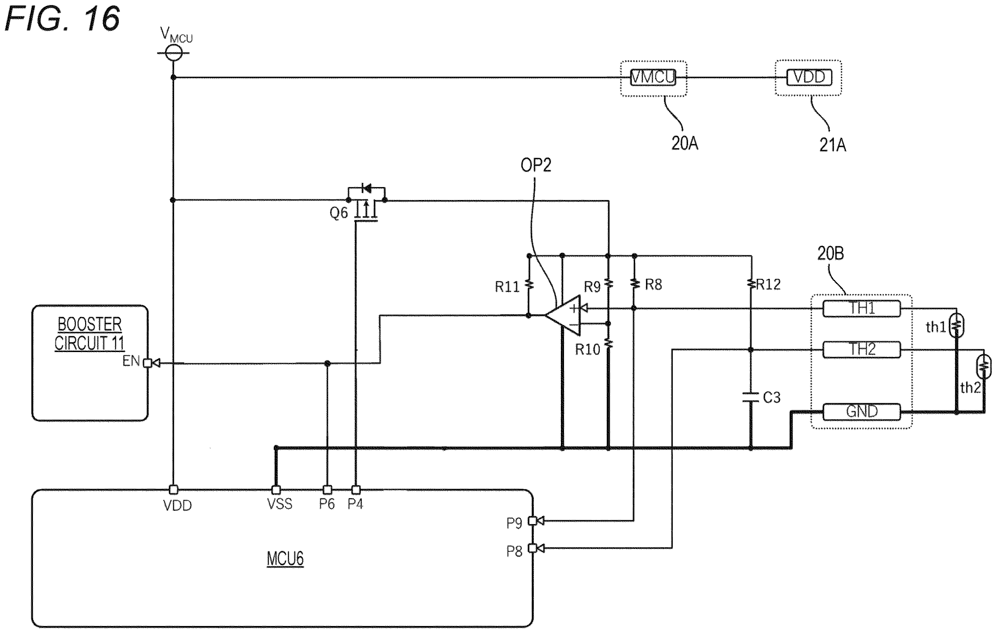

In the above-described protection circuit, both the FF9 and the AND gate 10 may be omitted. FIG. 16 is a circuit diagram corresponding to FIG. 13 in a case where the FF9 and the AND gate 10 are omitted. In the case where the FF9 and the AND gate 10 are omitted, the output terminal of the operational amplifier OP2 and the terminal P6 of the MCU 6 may be connected to the enable terminal EN of the booster circuit 11, as shown in FIG. 16. In the configuration shown in FIG. 16, when the temperature of the first thermistor th1 is equal to or higher than the threshold THD1 and the output of the operational amplifier OP2 gets to a low level, the enable terminal EN of the booster circuit 11 gets to a low level even in a state where a high level signal is output from the terminal P6 of the MCU 6. Accordingly, when the temperature of the sheet heater HTR is high, the output from the booster circuit 11 can be stopped. According to the configuration shown in FIG. 16, since the FF9 and the AND gate 10 can be omitted, the power supply unit 100 can be reduced in size, weight, and power saving.

### (Configuration of Heater FPC 24)

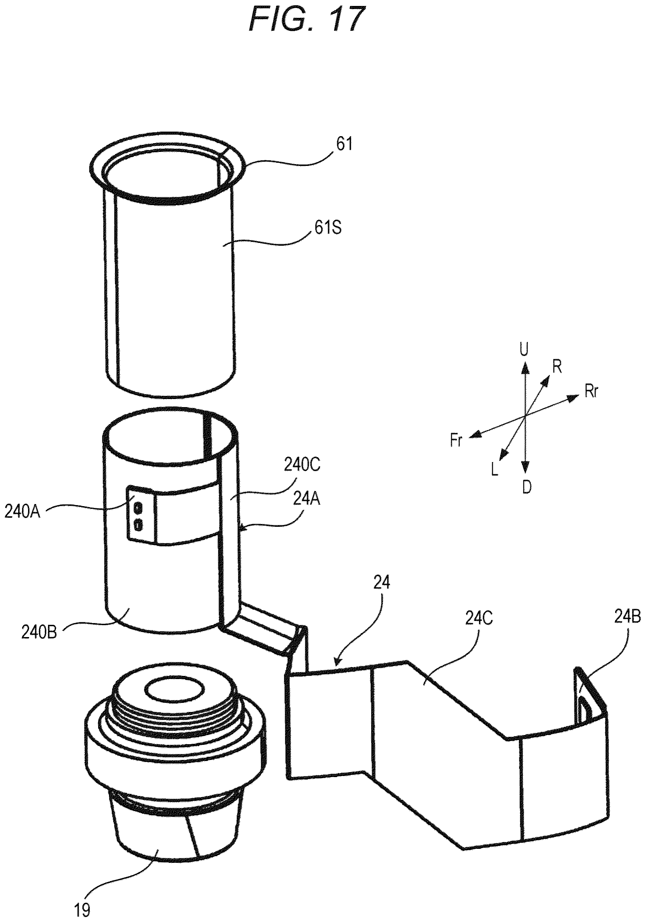

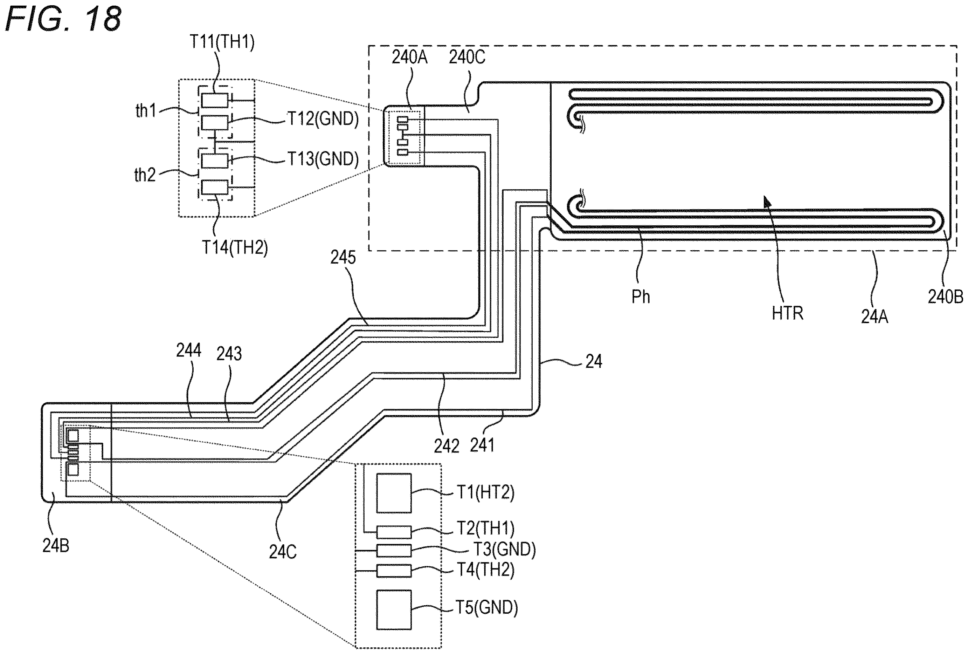

FIG. 17 is an exploded perspective view of the heating unit 60 and the flow path forming body 19 shown in FIG. 6. FIG. 18 is a developed view of the heater FPC 24 shown in FIG. 17. The heat transfer tube 61 and the flow path forming body 19 are fixed in a state where an upper end portion of the flow path forming body 19 is inserted through a lower end portion of the heat transfer tube 61. Accordingly, the flow path forming body 19 functions as a base with which a bottom of the second cartridge 120 abuts in a state where the second cartridge 120 is accommodated inside the heat transfer tube 61. The flow path forming body 19 is preferably made of a material having a high heat insulating function, for example, silicone. When the flow path forming body 19 is made of a material having a high heat insulating function, the heat of the sheet heater HTR is transmitted not only to the second cartridge 120 but also to the flow path forming body 19 on a lower end side of the heat transfer tube 61.

The heater FPC 24 includes a winding region 24A which is wound around and fixed to an outer peripheral surface 61S of the heat transfer tube 61 formed of a cylindrical body, a connector region 24B which is inserted into the heater connector 20B of the main substrate 20, and a coupling region 24C which couples the winding region 24A and the connector region 24B.

The winding region 24A includes a thermistor mounting region 240A in which the first thermistor th1 and the second thermistor th2 are mounted, a heater region 240B in which a conductive pattern Ph constituting the sheet heater HTR is formed, and an intermediate region 240C between the thermistor mounting region 240A and the heater region 240B. As described above, since the sheet heater HTR, the first thermistor th1, and the second thermistor th2 are mounted on the same FPC, a simple structure can be achieved as compared with a case where the sheet heater HTR and the thermistors are provided on different substrates, and the power supply unit 100 can be reduced in cost and size.

As shown in FIG. 17, the winding region 24A is wound around the outer peripheral surface 61S of the heat transfer tube 61 in a state where the thermistor mounting region 240A overlaps the heater region 240B on an opposite side of the heat transfer tube 61 when viewed in a radial direction of the heat transfer tube 61. With this configuration, since the sheet heater HTR, the first thermistor th1, and the second thermistor th2 can be disposed as close as possible, accuracy of the heating control of the sheet heater HTR and the protection control based on the protection circuit can be improved.

As shown in FIG. 18, in the thermistor mounting region 240A, a terminal T11, a terminal T12, a terminal T13, and a terminal T14 are disposed adjacently in an axial direction of the heat transfer tube 61. The positive terminal of the first thermistor th1 is connected to the terminal T11, and the negative terminal of the first thermistor th1 is connected to the terminal T12. The negative terminal of the second thermistor th2 is connected to the terminal T13, and the positive terminal of the second thermistor th2 is connected to the terminal T14. As shown in an enlarged view at an upper left part of FIG. 18, the first thermistor th1 and the second thermistor th2 are mounted adjacently in the axial direction of the heat transfer tube 61 in the thermistor mounting region 240A in a state where longitudinal directions thereof coincide with the axial direction of the heat transfer tube 61.

As described above, since the first thermistor th1 and the second thermistor th2 are disposed adjacently in the axial direction of the heat transfer tube 61, a width of the thermistor mounting region 240A in the axial direction can be increased as compared with a configuration in which the first thermistor th1 and the second thermistor th2 are disposed adjacently in a peripheral direction of the heat transfer tube 61. Since the longitudinal directions of the first thermistor th1 and the second thermistor th2 coincide with the axial direction of the heat transfer tube 61, the width of the thermistor mounting region 240A in the axial direction can be increased as compared with a configuration in which the longitudinal directions of the first thermistor th1 and the second thermistor th2 are orthogonal to the axial direction of the heat transfer tube 61. Accordingly, durability of the heater FPC 24 can be improved.

As long as the longitudinal directions of the first thermistor th1 and the second thermistor th2 are not orthogonal to the axial direction of the heat transfer tube 61, an effect that the width of the thermistor mounting region 240A in the axial direction can be increased is obtained.

The second thermistor th2 is disposed at a position closer to a center of the sheet heater HTR in the axial direction of the heat transfer tube 61 (the same as a short direction of the sheet heater HTR and the upper-lower direction of the power supply unit 100) than the first thermistor th1. That is, a shortest distance between the center of the sheet heater HTR and the second thermistor th2 in the axial direction of the heat transfer tube 61 (an upper-lower direction in FIG. 18) is shorter than a shortest distance between the center of the sheet heater HTR and the first thermistor th1 in the axial direction. According to the configuration, the second thermistor th2 disposed closer to the center of the sheet heater HTR in the axial direction is less susceptible to an air cooling effect than the first thermistor t1. Therefore, the accurate temperature of the sheet heater HTR can be reflected. By performing the heating control of the heater using the second thermistor th2, the accuracy of the heating control of the sheet heater HTR can be improved.

Further, the second thermistor th2 is disposed closer to the flow path forming body 19 than the first thermistor th1 in the upper-lower direction of the power supply unit 100. That is, a shortest distance between the second thermistor th2 and the flow path forming body 19 is shorter than a shortest distance between the first thermistor th1 and the flow path forming body 19. In a case where the flow path forming body 19 is made of a material having a high heat insulating property such as silicone, the temperature of the second thermistor th2 closer to the flow path forming body 19 exhibits a lower value than the temperature of the first thermistor th1 because the heat is absorbed by the flow path forming body 19. In the present embodiment, since the heating control of the sheet heater HTR is executed by using the second thermistor th2 having such a relatively low temperature, an effect that the temperature of the sheet heater HTR is less likely to reach a high temperature can be obtained. Meanwhile, the temperature of the first thermistor th1 exhibits a higher value than the temperature of the second thermistor th2 due to a distance from the flow path forming body 19. That is, in a case where the sheet heater HTR is excessively heated, the first thermistor th1 reaches a high temperature state reflecting the temperature earlier. Therefore, when the sheet heater HTR reaches a high temperature, the protection circuit can be quickly operated, and the safety can be improved.

As shown in an enlarged view at a lower center part of FIG. 18, in the connector region 24B, a terminal T1, a terminal T2, a terminal T3, a terminal T4, and a terminal T5 are disposed adjacently in this order in the upper-lower direction. In FIG. 18, for each of the terminal T1 to the terminal T5, a name of the terminal of the heater connector 20B which is a connection destination is described in parentheses. Although FIG. 12 illustrates one terminal GND provided in the heater connector 20B, the heater connector 20B actually includes two terminals GND as shown in FIG. 18.

One end of a conductive pattern 242 implemented by a one conductive wire is connected to the terminal T1. The other end of the conductive pattern 242 is connected to one end of a conductive pattern Ph implemented by one conductive wire. One end of a conductive pattern 241 implemented by one conductive wire is connected to the other end of the conductive pattern Ph. The other end of the conductive pattern 241 is connected to the terminal T5.

One end of a conductive pattern 243 implemented by a one conductive wire is connected to the terminal T2. The other end of the conductive pattern 243 is connected to the terminal T11. One end of a conductive pattern 245 implemented by one conductive wire is connected to the terminal T4. The other end of the conductive pattern 245 is connected to the terminal T14. One end of a conductive pattern 244 implemented by one conductive wire is connected to the terminal T3. The terminal T12 and the terminal T13 are connected in parallel to the other end of the conductive pattern 244. The conductive patterns of the heater FPC 24 are insulated from one another. In FIG. 18, for each of the terminal T11 to the terminal T14, a name of the terminal of the heater connector 20B which is an electrical connection destination is described in parentheses.

In the heater FPC 24, the first thermistor th1 and the second thermistor th2 share the conductive pattern 244 for connection to the ground. Accordingly, as compared with a case where conductive patterns for connecting the first thermistor th1 and the second thermistor th2 to the ground are provided, the wiring of the heater FPC 24 can be simplified and the manufacturing cost of the power supply unit 100 can be reduced. Widths of the conductive pattern 241 and the conductive pattern 242 connected to the conductive pattern Ph can be made as larger as possible in the limited heater FPC 24. Accordingly, parasitic resistance of the conductive pattern 241 and the conductive pattern 242 can be reduced, and thus electric power can be more efficiently supplied to the sheet heater HTR.

In the heater FPC 24, the conductive pattern 244 for connecting the first thermistor th1 and the second thermistor th2 to the ground and the conductive pattern 241 for connecting the conductive pattern Ph to the ground are separately provided. Accordingly, it is possible to prevent the first thermistor th1 and the second thermistor th2 from being affected by a fluctuation in a potential of the conductive pattern 241 connected to the conductive pattern Ph. Therefore, the accuracy of the control using the first thermistor th1 and the second thermistor th2 can be improved, and the safety of the power supply unit 100 can be improved. A conductive pattern for connecting the first thermistor th1 to the ground and a conductive pattern for connecting the second thermistor th2 to the ground may be separately provided in the heater FPC 24, and any one of the two conductive patterns may be connected to the terminal T5. With the configuration, the accuracy of control using either one of the first thermistor th1 and the second thermistor th2 can also be improved.

### (Configuration and Operation of Restart Circuit RBT)

FIG. 19 is a circuit diagram showing electronic components related to restart of the MCU 6 and extracted from the circuit shown in FIG. 12. FIG. 19 shows the restart circuit RBT. The restart circuit RBT includes a voltage dividing circuit including the resistor R3 and the resistor R4, the switch BT, the terminal KEY and the terminal GND of the main connector 20A, the switch Q7, the switch Q9, the charging IC 3, the LDO 4, and the terminal NRST of the debug connector 20E. In the present embodiment, the MCU 6 can be restarted by the restart circuit RBT according to an operation of the switch BT (as an example, a long-press operation) and a command from an external device connected to the debug connector 20E. The MCU 6 is configured to restart when a signal input to the terminal P27 continues to be at a low level for a predetermined time. Further, the charging IC 3 is configured to restart when a signal input to the terminal QON( ) continues to be at a low level for a predetermined time.

### (Reset of MCU 6 Using Switch BT)

First, an operation when the MCU 6 is restarted without using the debug connector 20E will be described.

The resistor R3 and the resistor R4 have such resistance values that an output of the voltage dividing circuit including the resistor R3 and the resistor R4 gets to a high level in a state where the switch BT is not pressed down. Since a high level signal is input to the terminal QON( ) of the charging IC 3, the charging IC 3 is not reset in this state, and the output of the system power supply voltage V_{SYS} from the output terminal SYS is continued. Since the output of the system power supply voltage V_{SYS} is continued, the output of the system power supply voltage V_{MCU} from the output terminal OUT of the LDO 4 is also continued. Therefore, the MCU 6 continues to operate without stopping. Further, a high level signal is input to the gate terminal of the switch Q7. Therefore, when the USB connection is established (when the bus voltage V_{BUS} is output from the charging IC 3), the switch Q7 gets to an ON state, and as a result, a potential of the gate terminal of the switch Q9 gets to a low level (ground level), and the switch Q9 gets to an OFF state. When the switch Q9 is in an OFF state, a potential of the terminal P27 of the MCU 6 is undefined, so that the MCU 6 is not restarted.

The resistor R3 and the resistor R4 have such resistance values that an output of the voltage dividing circuit including the resistor R3 and the resistor R4 gets to a low level in a state where the switch BT is pressed down. In other words, the resistor R3 and the resistor R4 have such resistance values that a value obtained by dividing the system power supply voltage V_{MCU} gets to a low level. Since a low level signal is input to the terminal QON( ) of the charging IC 3, the charging IC 3 stops outputting the system power supply voltage V_{SYS} from the output terminal SYS when this state continues for a predetermined time. When the output of the system power supply voltage V_{SYS} is stopped, the voltage output from the LDO 4 is stopped, the system power supply voltage V_{MCU} is not input to the terminal VDD of the MCU 6, and the MCU 6 is stopped.

Further, a low level signal is input to the gate terminal of the switch Q7. Therefore, when the USB connection is established (when the bus voltage V_{BUS} is output from the charging IC 3), the switch Q7 gets to an OFF state, and as a result, the potential of the gate terminal of the switch Q9 gets to a high level (bus voltage V_{BUS}), and the switch Q9 gets to an ON state. When the switch Q9 gets to an ON state, the potential of the terminal P27 of the MCU 6 gets to a low level (ground level). When the switch BT is continuously pressed down for a predetermined time, a low level signal is input to the terminal P27 of the MCU 6 for a predetermined time, and thus the MCU 6 executes the restart processing. When the press-down of the switch BT ends, the charging IC 3 resumes the output of the system power supply voltage V_{SYS}, so that the system power supply voltage V_{MCU} is input to the terminal VDD of the MCU 6 which is stopped, and the MCU 6 is started up.

### (Reset of MCU 6 Using Debug Connector 20E)

When the MCU 6 is restarted using the debug connector 20E, the USB connection is performed, and then an external device is connected to the debug connector 20E. In this state, if the switch BT is not pressed, the switch Q9 gets to an OFF state, and thus the potential of the terminal P27 of the MCU 6 depends on an input from the external device. Therefore, when an operator operates the external device to input a low-level restart signal to the terminal NRST, the restart signal is continuously input to the terminal P27 for a predetermined time. By receiving the restart signal, the MCU 6 executes the restart processing.

According to the restart circuit RBT shown in FIG. 19, a low level signal generated by pressing down the switch BT is input not only to the terminal QON( ) of the charging IC 3 but also to the terminal P27 of the MCU 6. Therefore, even when the MCU 6 is frozen, the MCU 6 can be restarted by stopping the output from the charging IC 3. Even when the charging IC 3 is not reset due to some reason, the MCU 6 can be restarted by inputting a low level signal to the terminal P27 as long as the MCU 6 is not frozen. As described above, since the restart in two systems is possible, the MCU 6 can be reliably restarted by a simple operation of just pressing down the switch BT.

Further, according to the restart circuit RBT shown in FIG. 19, the MCU 6 can be restarted from an external device using the debug connector 20E. Even when a low level signal is input from the external device to the terminal P27 of the MCU 6, the presence of the switch Q9 prevents the signal from being transmitted to the terminal QON( ) of the charging IC. As described above, since the signal input to the debug connector 20E can be separated from the signal generated by the operation of the switch BT, an operation of the restart circuit RBT can be stabilized. In FIG. 19, a configuration in which the terminal NRST and the terminal QON( ) of the charging IC 3 are connected is also assumed, but such a configuration is not adopted in FIG. 19. Accordingly, the restart circuit RBT can be simplified and the manufacturing cost of the power supply unit 100 can be reduced as compared with a case where the debug connector 20E is connected to the terminal QON( ).

In the restart circuit RBT shown in FIG. 19, the restart of the MCU 6 using the switch BT can be performed only in a case where the USB connection is established. As described above, by allowing the MCU 6 to be restarted only in a state where the power supply ba can be charged, even if the remaining amount of the power supply ba is low at the time of restarting the MCU 6, the MCU 6 can be reliably restarted by the external power supply.

### (Modification of Restart Circuit RBT)

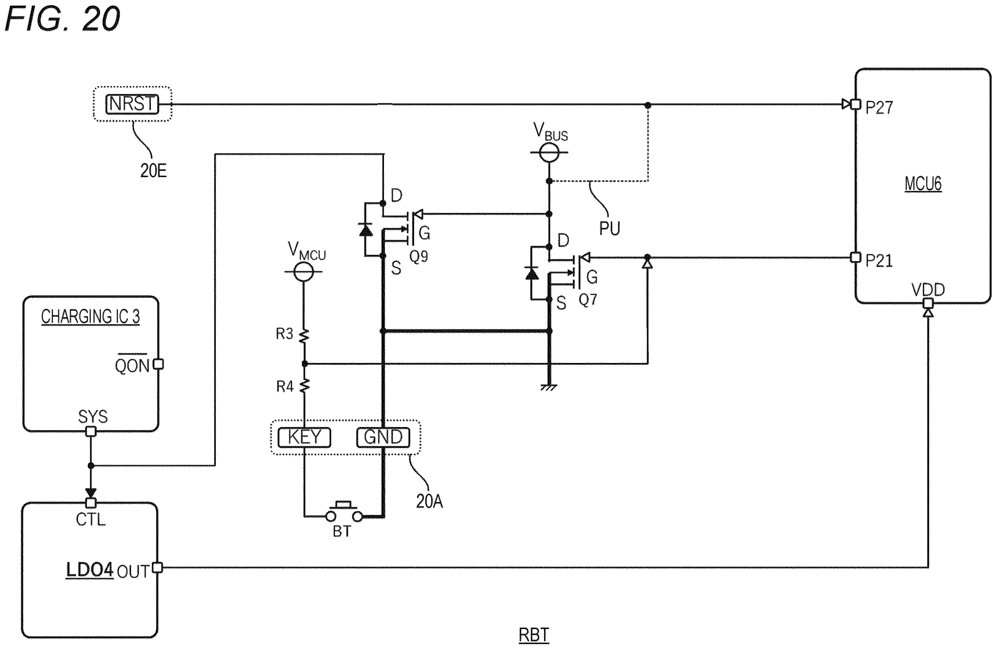

FIG. 20 is a diagram showing a modification of the restart circuit RBT shown in FIG. 19. The restart circuit RBT shown in FIG. 20 has the same configuration as that of FIG. 19 except that a connection destination of the drain terminal of the switch Q9 is changed from the terminal P27 to the control terminal CTL of the LDO 4, and a connection between the voltage dividing circuit including the resistor R3 and the resistor R4 and the terminal QON( ) of the charging IC 3 is deleted. In the restart circuit RBT shown in FIG. 20, when the MCU 6 is restarted without using the debug connector 20E, it is necessary to perform a USB connection.

In the restart circuit RBT shown in FIG. 20, in a state where the USB connection is established and the switch BT is not pressed down, the output of the voltage dividing circuit including the resistor R3 and the resistor R4 gets to a high level. A high level signal is input to the gate terminal of the switch Q7. Therefore, the switch Q7 gets to an ON state, and as a result, a potential of the gate terminal of the switch Q9 gets to a low level (ground level), and the switch Q9 gets to an OFF state. When the switch Q9 is in an OFF state, a low level signal is not input to the control terminal CTL of the LDO 4. Therefore, the MCU 6 continues to operate.

In the restart circuit RBT shown in FIG. 20, in a state where the USB connection is established and the switch BT is pressed down, the output of the voltage dividing circuit including the resistor R3 and the resistor R4 gets to a low level. A low level signal is input to the gate terminal of the switch Q7. Therefore, the switch Q7 gets to an OFF state, and as a result, the potential of the gate terminal of the switch Q9 gets to a high level (bus voltage V_{BUS}), and the switch Q9 gets to an ON state. When the switch Q9 gets to an ON state, the control terminal CTL of the LDO 4 is connected to the ground, so that a signal input to the control terminal CTL gets to a low level. When a low level signal is continuously input to the control terminal CTL for a predetermined time, the LDO 4 stops the voltage output from the output terminal OUT. Therefore, when the switch BT is continuously pressed down for a predetermined time, the supply of the system power supply voltage V_{MCU} to the MCU 6 is stopped, and the MCU 6 is stopped. When the press-down of the switch BT ends, the switch Q9 gets to an OFF state, so that the signal input to the control terminal CTL returns to a high level (system power supply voltage V_{SYS}). Accordingly, since the LDO 4 resumes the output of the system power supply voltage V_{MCU}, the system power supply voltage V_{MCU} is input to the terminal VDD of the MCU 6 which is stopped, and the MCU 6 is started up.

In the restart circuit RBT shown in FIG. 20, when the MCU 6 is restarted using the debug connector 20E, an external device is connected to the debug connector 20E. In this state, when an operator operates the external device to input a low-level restart signal to the terminal NRST, the restart signal is continuously input to the terminal P27 for a predetermined time. By receiving the restart signal, the MCU 6 executes the restart processing.

In the restart circuit RBT shown in FIG. 20, even when the switch BT is long-pressed, a low level signal is not input to the terminal P27 of the MCU 6. Therefore, as compared with the restart circuit RBT shown in FIG. 19, the circuit can be simplified and the manufacturing cost of the power supply unit 100 can be reduced.

In the restart circuit RBT shown in FIG. 20, a wiring PU indicated by a broken line in the figure may be added. The wiring PU is provided to pull up the potential of the terminal P27 of the MCU 6 to a high level by the bus voltage V_{BUS}. By adding the wiring PU, the potential of the terminal P27 is not unstable even in a state where a low level signal is not input to the terminal P27, so that the operation of the power supply unit 100 can be stabilized.

In the circuit shown in FIG. 12, the switch Q5 may be connected between the terminal GND of the heater connector 20B, which is connected to the negative terminal of the sheet heater HTR, and the ground provided on the main substrate 20. In this configuration, the switch Q5 is preferably an N-channel switch.

In the present description, at least the following matters are described. In parentheses, corresponding constituent components and the like in the above-mentioned embodiment are indicated, but the present invention is not limited thereto.
(1) A power supply unit of an aerosol generation device, the power supply unit including:
   a power supply (power supply ba);
   an inhalation sensor (inhalation sensor 15) configured to provide an output based on inhalation of a user;
   a controller (MCU 6) configured to control, based on the output of the inhalation sensor, power supply to an atomizer (liquid heater) that atomizes an aerosol source;
   a circuit substrate (puff sensor substrate 21) on which the inhalation sensor is mounted;
   a housing (case 3a) configured to accommodate the power supply, the inhalation sensor, the controller, and the circuit substrate; and
   a sensor holding portion (sensor holding portion 55) into which the inhalation sensor is inserted and which fixes a position of the inhalation sensor inside the housing, in which
   the inhalation sensor protrudes from the circuit substrate in a plan view viewed in a thickness direction of the circuit substrate.

According to (1), the inhalation sensor can be inserted into the sensor holding portion by pushing a side surface of the inhalation sensor protruding from the circuit substrate. Therefore, during manufacturing of the power supply unit, a risk of touching a movable electrode and a fixed electrode of the inhalation sensor with a finger or the like is reduced, and a failure of the inhalation sensor can be prevented, and a manufacturing yield of the power supply unit is improved.

(2) The power supply unit of the aerosol generation device according to (1), in which
the circuit substrate includes a wide portion (third portion 213) and a narrow portion (second portion 212 and first portion 211) having a width smaller than a width of the wide portion, and
the inhalation sensor is mounted on the narrow portion.

According to (2), by mounting many electric components other than the inhalation sensor on the wide portion, an area of the circuit substrate can be utilized more effectively, so that the power supply unit can be reduced in size and cost.

(3) The power supply unit of the aerosol generation device according to (2), in which
the width of the wide portion is equal to or larger than a width of the inhalation sensor.

According to (3), by mounting many electric components other than the inhalation sensor on the wide portion, an area of the circuit substrate can be utilized more effectively, so that the power supply unit can be reduced in size and cost.

(4) The power supply unit of the aerosol generation device according to (2) or (3), in which
the narrow portion is located at one end of the circuit substrate in a longitudinal direction of the circuit substrate.

According to (4), as compared with a configuration in which the wide portion is provided at both ends of the circuit substrate in the longitudinal direction, stress generated in the circuit substrate can be prevented from concentrating on the narrow portion, so that a mechanical strength of the circuit substrate is improved.

(5) The power supply unit of the aerosol generation device according to any one of (2) to (4), in which
the narrow portion of the circuit substrate includes a first portion (first portion 211) having a width smaller than that of the wide portion and a second portion (second portion 212) connecting the first portion and the wide portion,
an angle (angle θ1) of a vertex formed by the wide portion and the second portion is 90 degrees or more, and
an angle (angle θ2) of a vertex formed by the first portion and the second portion is 90 degrees or more.

According to (5), a conductive pattern passing near an edge of the circuit substrate does not have an acute curve at a portion where the width of the circuit substrate changes. Accordingly, parasitic resistance and parasitic inductance of the conductive pattern are reduced, so that heat and noise which may be generated on the circuit substrate are reduced.

(6) The power supply unit of the aerosol generation device according to any one of (2) to (5), further including:
a protective component (varistor V) that protects other electric components or the controller mounted on the circuit substrate from a signal output from the inhalation sensor, or a protective component (capacitor C2) that protects the inhalation sensor from electric power input to the inhalation sensor, in which
the inhalation sensor is mounted on the narrow portion on one (back surface 215) of main surfaces of the circuit substrate, and
the protective component is mounted on the narrow portion on the other (front surface 214) of the main surfaces of the circuit substrate.

According to (6), not only the area of the circuit substrate can be utilized more effectively, but also noise input to and output from the inhalation sensor can be more quickly processed by the protective component, and thereby the power supply unit is reduced in size and cost and an operation thereof is stabilized.

(7) The power supply unit of the aerosol generation device according to any one of (1) to (6), in which
the sensor holding portion is disposed such that a radial direction of an insertion hole (through hole 552A) into which the inhalation sensor is inserted intersects any two directions among a longitudinal direction (upper-lower direction), a short direction (front-rear direction), and a thickness direction (left-right direction) of the housing.

According to (7), as compared with a configuration in which the radial direction of the insertion hole only intersects any one direction of the housing, a length in any direction of the housing can be reduced, and thus the power supply unit can be reduced in size.

(8) The power supply unit of the aerosol generation device according to (7), in which
the housing includes a first portion (first case 3A) and a second portion (second case 3B) that are detachable, and
the power supply unit further includes a connector (debug connector 20E) configured to allow rewriting of information stored in the controller,
the sensor holding portion is exposed to an outside only when the first portion of the first portion and the second portion is detached, and
the connector is exposed to an outside only when the second portion of the first portion and the second portion is detached.

According to (8), when the information stored in the controller is rewritten, the inhalation sensor is not exposed to the outside, so that the inhalation sensor is less likely to fail.

(9) The power supply unit of the aerosol generation device according to (7), further including:
a chassis (chassis 50) from which the housing is detachable and which includes a curved portion (cartridge holding portion 51) having a curved shape, in which
the sensor holding portion is fixed to the curved portion.

According to (9), by forming the sensor holding portion into a shape conforming to, for example, the curved portion, a length in any direction of the housing can be further reduced, so that the power supply unit can be further reduced in size.

(10) The power supply unit of the aerosol generation device according to (9), further including:
a cavity (hollow portion of the cartridge holding portion 51) configured to allow insertion of a cartridge (first cartridge 110) including the aerosol source, in which
the curved portion defines the cavity.

According to (10), since the sensor holding portion is fixed to a portion of the chassis which is curved for another purpose, a space inside the housing can be more effectively utilized, and the power supply unit can be further reduced in size.

(11) The power supply unit of the aerosol generation device according to any one of (1) to (6), in which
the sensor holding portion includes an insertion hole (through hole 552A) abutted with a side surface (side surface 153) of the inhalation sensor, and a cutout (cutout 553) provided in a part of the insertion hole.

According to (11), since the side surface of the inhalation sensor can be easily pushed due to the cutout of the sensor holding portion, the inhalation sensor can be easily inserted into the sensor holding portion by pushing the side surface of the inhalation sensor protruding from the circuit substrate.

(12) The power supply unit of the aerosol generation device according to (11), in which
the sensor holding portion is disposed such that a radial direction of the insertion hole intersects any two directions among a longitudinal direction, a short direction, and a thickness direction of the housing,
the power supply unit further includes a chassis (chassis 50) from which the housing (first case 3A) is detachable, and
the cutout is exposed to an outside in a state where the housing is detached from the chassis.

According to (12), as compared with a configuration in which the cutout is not exposed to the outside in a state where the housing is detached from the chassis, maintenance of the inhalation sensor and attachment work to the sensor holding portion can be facilitated.

### REFERENCE SIGNS LIST

100: power supply unit
3a: case
6: MCU
15: inhalation sensor
21: puff sensor substrate
55: sensor holding portion
ba: power supply

## Claims

1. A power supply unit of an aerosol generation device, the power supply unit comprising:
a power supply;
an inhalation sensor configured to provide an output based on inhalation of a user;
a controller configured to control, based on the output of the inhalation sensor, power supply to an atomizer that atomizes an aerosol source;
a circuit substrate on which the inhalation sensor is mounted;
a housing configured to accommodate the power supply, the inhalation sensor, the controller, and the circuit substrate; and
a sensor holding portion into which the inhalation sensor is inserted and which fixes a position of the inhalation sensor inside the housing, wherein
the inhalation sensor protrudes from the circuit substrate in a plan view viewed in a thickness direction of the circuit substrate.

2. The power supply unit of the aerosol generation device according to claim 1, wherein
the circuit substrate includes a wide portion and a narrow portion having a width smaller than a width of the wide portion, and
the inhalation sensor is mounted on the narrow portion.

3. The power supply unit of the aerosol generation device according to claim 2, wherein
the width of the wide portion is equal to or larger than a width of the inhalation sensor.

4. The power supply unit of the aerosol generation device according to claim 2 or 3, wherein
the narrow portion is located at one end of the circuit substrate in a longitudinal direction of the circuit substrate.

5. The power supply unit of the aerosol generation device according to any one of claims 2 to 4, wherein
the narrow portion of the circuit substrate includes a first portion having a width smaller than that of the wide portion and a second portion connecting the first portion and the wide portion,
an angle of a vertex formed by the wide portion and the second portion is 90 degrees or more, and
an angle of a vertex formed by the first portion and the second portion is 90 degrees or more.

6. The power supply unit of the aerosol generation device according to any one of claims 2 to 5, further comprising
a protective component that protects other electric components or the controller mounted on the circuit substrate from a signal output from the inhalation sensor, or a protective component that protects the inhalation sensor from electric power input to the inhalation sensor, wherein
the inhalation sensor is mounted on the narrow portion on one of main surfaces of the circuit substrate, and
the protective component is mounted on the narrow portion on the other of the main surfaces of the circuit substrate.

7. The power supply unit of the aerosol generation device according to any one of claims 1 to 6, wherein
the sensor holding portion is disposed such that a radial direction of an insertion hole into which the inhalation sensor is inserted intersects any two directions among a longitudinal direction, a short direction, and a thickness direction of the housing.

8. The power supply unit of the aerosol generation device according to claim 7, wherein
the housing includes a first portion and a second portion that are detachable,
the power supply unit further comprises a connector configured to allow rewriting of information stored in the controller,
the sensor holding portion is exposed to an outside only when the first portion of the first portion and the second portion is detached, and
the connector is exposed to an outside only when the second portion of the first portion and the second portion is detached.

9. The power supply unit of the aerosol generation device according to claim 7, further comprising:
a chassis from which the housing is detachable and which includes a curved portion having a curved shape, wherein
the sensor holding portion is fixed to the curved portion.

10. The power supply unit of the aerosol generation device according to claim 9, further comprising:
a cavity configured to allow insertion of a cartridge including the aerosol source, wherein
the curved portion defines the cavity.

11. The power supply unit of the aerosol generation device according to any one of claims 1 to 6, wherein
the sensor holding portion includes an insertion hole abutted with a side surface of the inhalation sensor, and a cutout provided in a part of the insertion hole.

12. The power supply unit of the aerosol generation device according to claim 11, wherein
the sensor holding portion is disposed such that a radial direction of the insertion hole intersects any two directions among a longitudinal direction, a short direction, and a thickness direction of the housing,
the power supply unit further comprises a chassis from which the housing is detachable, and
the cutout is exposed to an outside in a state where the housing is detached from the chassis.
